# EUROPEAN PATENT APPLICATION

(11) **EP 1 455 558 A2**
(43) Date of publication of application: **08.09.2004**
(21) Application number: 04005340.7
(22) Date of filing: 05.03.2004
(51) Int. Cl.: H05K 1/16

(54) **Printed wiring boards having capacitors and methods of making thereof**

(30) Priority: 07.03.2003 US 453129 P; 02.12.2003 US 725888
(71) Applicant: E.I. du Pont de Nemours and Company, Wilmington, DE 19805 (US)
(72) Inventor: Borland, William, Cary North Carolina 27513 (US); McGregor, David R., Cary North Carolina 27511 (US); Ferguson, Saul, Durham North Carolina 27713 (US)
(74) Representative: Hughes, Andrea Michelle

(57) **Abstract**

In a printed wiring board, a plurality of stacked innerlayer panels 100, 200, 300 have capacitors 105, 205, 305 connected in parallel by connecting a first electrode 110 of a first panel with a first electrode 210 of a second panel, and similarly connecting second electrodes 120, 220 of the first and second panels. The innerlayer panel having capacitors connected in parallel provides a high capacitance in a small x-y area. An alternative printed wiring board has a capacitor having a first foil electrode 101, and second and third electrodes located on opposite sides of the first foil electrode. Yet another printed wiring board has capacitors formed as an array of discrete foil electrodes spaced from an array of discrete printed electrodes. Forming discrete interconnected electrodes allows the electrodes to be fired without excessive thermal coefficient of expansion stresses damaging the electrodes.

## Description

### BACKGROUND

### TECHNICAL FIELD

The technical field is embedded capacitors. More particularly, the technical field includes embedded capacitors that may be embedded in printed wiring boards.

### BACKGROUND ART

The practice of embedding passive circuit elements in printed wiring boards (PWB) allows for reduced circuit size and improved circuit performance. The passive circuit elements are typically embedded in panels that are stacked and connected by interconnection circuitry, the stack of panels forming the printed wiring board. The panels can be generally referred to as "innerlayer panels."

Often the device in which a printed wiring board is to be incorporated has specific dimensional restraints. For example, a handheld device or semiconductor package may require small-form circuits, imposing length and width, or "x and y" or "x-y" limitations on a printed wiring board's dimensions. Other devices, such as ultra-thin packages, may impose thickness, or "z" limitations on printed wiring boards. In printed wiring boards, space is often at a premium, and passive elements such as capacitors should therefore occupy a relatively small area of an innerlayer panel. Thus it is advantageous if capacitors within printed wiring boards are of small size and have high capacitance values.

One approach to providing a capacitor circuit component of high capacitance is to form capacitor electrodes having large x-y dimensions, or a large surface area or "footprint." However, when making fired-on-foil capacitors, the thermal coefficient of expansion (TCE) differences between the foil and the fired materials cause stresses in the capacitor structure. The stress forces are proportional to the x-y dimension of the electrode layers, and large electrode layers therefore may be susceptible to cracking due to large TCE stresses.

The wiring of passive circuit elements such as capacitors embedded in an innerlayer panel contribute to the circuit loop inductance (also known as "lead inductance") of the panel circuit. High circuit loop inductances are undesirable in most applications. A capacitor's contribution to circuit loop inductance is determined in part by its termination separation. A capacitor "termination" can be generally defined as the point at which a circuit conductor, such as a conductive trace or conductive lead, is connected to a capacitor electrode or electrodes. Conventional surface mount multilayer capacitors or fired-on-foil capacitor elements have one termination located at one edge of the capacitor, and another termination located at an opposite edge of the capacitor, rather than locating the terminations within a plan view surface area, or footprint of the capacitor electrodes. Locating the terminations at the opposite edges of a capacitor results in the highest termination separation for the capacitor, and a correspondingly high contribution to circuit loop inductance. Locating capacitor terminations at opposite ends of a capacitor has the additional disadvantageous effect of giving the capacitor a large overall footprint in the printed wiring board.

### SUMMARY

According to one embodiment of a printed wiring board and a method of making thereof, the printed wiring board comprises a plurality of innerlayer panels. One or more of the innerlayer panels comprise capacitors that may be connected in parallel. A first one of the innerlayer panels comprises a first electrode, a dielectric disposed over the first electrode, and a second electrode disposed over the dielectric. A second one of the innerlayer panels also comprises a first electrode, a dielectric disposed over the first electrode, and a second electrode disposed over the dielectric. The second innerlayer panel is stacked with the first innerlayer panel. The respective first electrodes of the two innerlayer panels are electrically coupled, and the respective second electrodes of the two innerlayer panels are also electrically coupled. The capacitors of the innerlayer panels are thereby connected in parallel.

According to the printed wiring board embodiment having stacked capacitors (in the z direction) connected in parallel, a high capacitance can be provided in a relatively small x-y area. This embodiment is particularly useful when the x-y surface area in a device is limited, while the limitations on the z dimension (or thickness) of the device are less restrictive. A printed wiring board constructed according this embodiment can include any number of innerlayer panels stacked and connected in parallel, thereby providing high capacitances within relatively small x-y surface areas.

According to another embodiment, a printed wiring board includes a plurality of stacked innerlayer panels, and one or more of the innerlayer panels includes a capacitor having electrodes disposed on either side of a foil electrode. The capacitor comprises the foil electrode, a first dielectric disposed over a first side of the foil electrode, a second dielectric disposed over a second side of the foil electrode, a second electrode disposed over the first dielectric, and a third electrode disposed over the second dielectric. Additional dielectric layers and electrodes may also be included on either side of the foil electrode.

According to the embodiment of the printed wiring board having capacitors with electrodes on either side of a foil electrode, a high capacitance is provided in a relatively small x-y surface area. This embodiment is particularly useful when the x-y surface area in a device is limited. A printed wiring board constructed according to the above embodiment can include any number of innerlayer panels stacked and having capacitors connected in parallel, thereby providing high capacitances within relatively small x-y areas.

According to yet another embodiment, a printed wiring board includes a plurality of innerlayer panels, and one or more of the innerlayer panels includes a capacitor formed from a foil carrier. The capacitor comprises a plurality of first electrodes disposed in a plane, a plurality of first conductive portions electrically connecting the first electrodes, a plurality of second electrodes formed from the foil carrier, a plurality of second conductive portions also formed from the foil carrier and electrically connecting the second electrodes, and a dielectric layer separating the first electrodes from the second electrodes. The first electrodes and the second electrodes are arranged so that the first electrodes are spaced across the dielectric from the second electrodes. The plurality of first and second electrodes, separated by the dielectric, thereby form a plurality of capacitors.

According to this embodiment, the innerlayer panels provide high capacitances within a relatively small z (thickness) dimension. This feature is particularly desirable when the z-dimension of a system or device is limited, and the x-y dimension is less constrained.

The above embodiment also allows a thin high capacitance component to be formed by fired-on-foil techniques. As discussed above, previous attempts to build high capacitance capacitors involved forming large continuous electrodes in order to obtain high capacitances. When these conventional capacitors were fired however, the TCE stresses between the metallic foil and the deposited layers often caused cracking. In the present embodiment, the total capacitance provided by the individual capacitors is large. TCE mismatch problems, however, are avoided because the surface area of each electrode and the associated dielectric layer is relatively small. The above embodiment also allows for routing of through-holes through the innerlayer panels, and for connection to the capacitors from either side of the innerlayer panels in which the capacitors are embedded.

Those skilled in the art will appreciate the above stated advantages and other advantages and benefits of various embodiments of the invention upon reading the following detailed description of the embodiments with reference to the below-listed drawings.

According to common practice, the various features of the drawings are not necessarily drawn to scale. Dimensions of various features may be expanded or reduced to more clearly illustrate the embodiments of the invention.

### BRIEF DESCRIPTION OF THE DRAWINGS

The detailed description will refer to the following drawings, wherein like numerals refer to like elements, and wherein:
FIG. 1A is a schematic plan view of a portion of a first embodiment of a printed wiring board having capacitors connected in parallel, seen from the perspective of line 1A-1A in FIG. 1B;
FIG. 1B is a schematic sectional view in front elevation of the first embodiment of the printed wiring board having capacitors connected in parallel, taken on line 1B-1B in FIG. 1A;
FIGS. 2A-2K illustrate stages of manufacture of a first embodiment of an innerlayer panel before incorporating the innerlayer panel into the printed wiring board illustrated in FIGS. 1Aand 1B;
FIG. 3 is a schematic sectional view in front elevation of a second embodiment of a printed wiring board having capacitors connected in parallel;
FIG. 4 is a schematic sectional view in front elevation of a third embodiment of a printed wiring board having capacitors connected in parallel;
FIGS. 5A-5G illustrate a method of manufacturing a first embodiment of an innerlayer panel having a capacitor with electrodes on either side of a foil electrode, before incorporating such panel into a printed wiring board;
FIG. 5H is a schematic sectional view of the printed wiring board embodiment including the innerlayer panel produced by the method illustrated in FIGS. 5A-5G;
FIG. 51 is a plan view of the innerlayer panel embodiment shown in FIG. 5F, seen from the perspective of line 5G-5G.
FIGS. 6A-6D illustrate a method of manufacturing a second embodiment of an innerlayer panel having a capacitor with electrodes on either side of a foil electrode, before incorporating such panel into a printed wiring board;

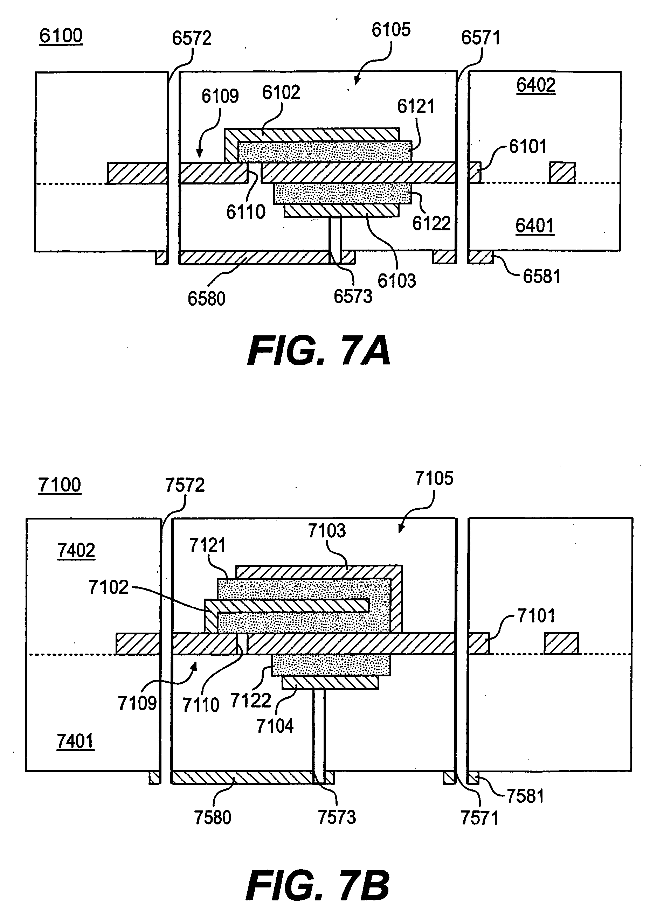

FIG. 7A illustrates schematically an alternative embodiment of an innerlayer panel having a capacitor with electrodes on either side of a foil electrode;
FIG. 7B illustrates schematically another alternative embodiment of an innerlayer panel having a capacitor with electrodes on either side of a foil electrode;

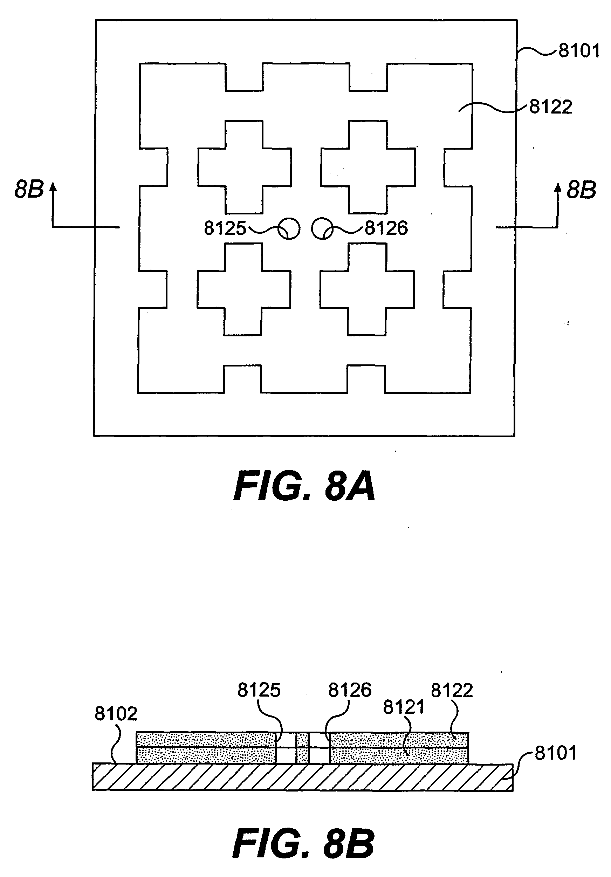

FIGS. 8A-8G illustrate schematically a method of manufacturing a first embodiment of an innerlayer panel having multiple capacitors formed from a foil carrier, before incorporating such panel into a printed wiring board;

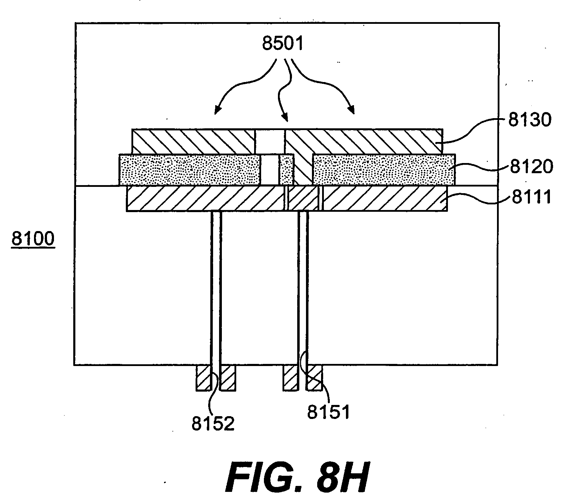

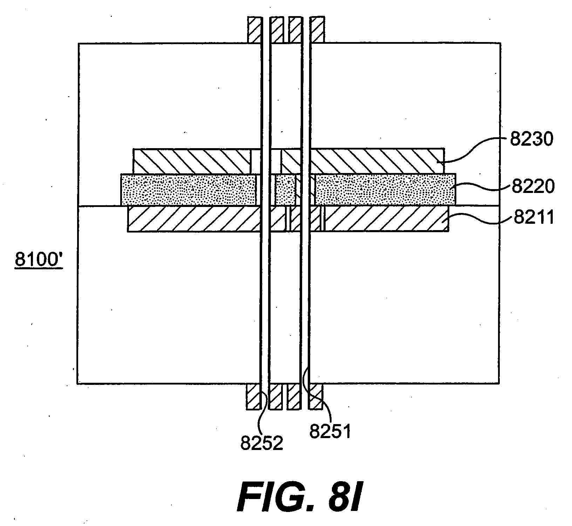

FIG. 8H is a schematic sectional view of the finished innerlayer panel having multiple capacitors formed from foil carrier;
FIG. 81 is a schematic sectional view of an alternative to the innerlayer panel illustrated in FIG. 8H;

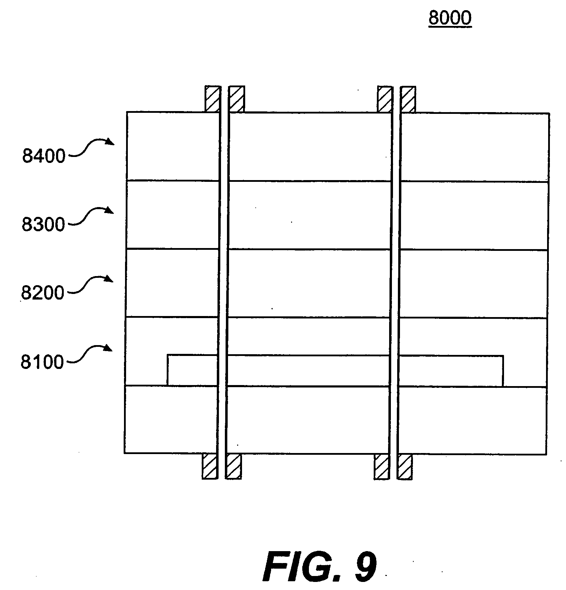

FIG. 9 is a schematic sectional view of the printed wiring board including the innerlayer panel of FIG. 8H; and

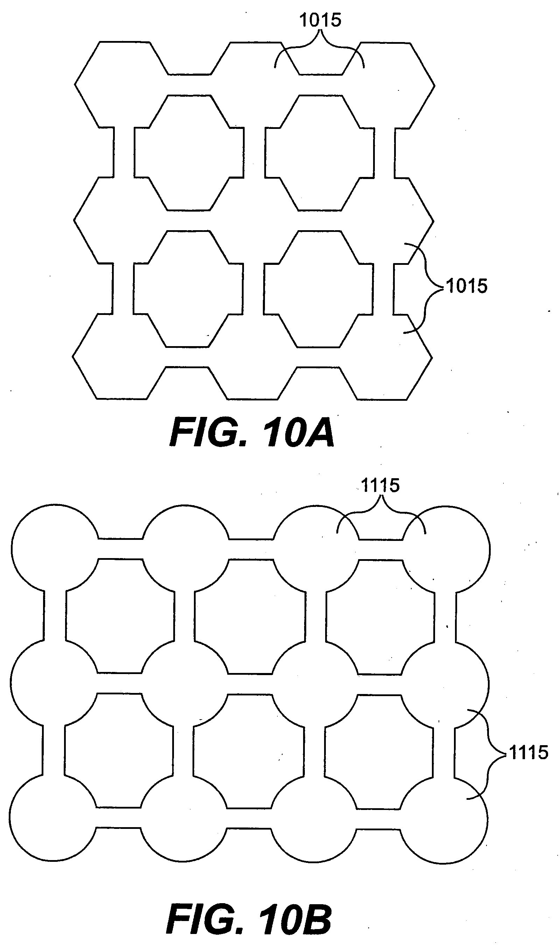

FIGS. 10A and 10B illustrate schematically alternative electrode arrangements in innerlayer panels having multiple capacitors formed from a foil carrier.

### DETAILED DESCRIPTION

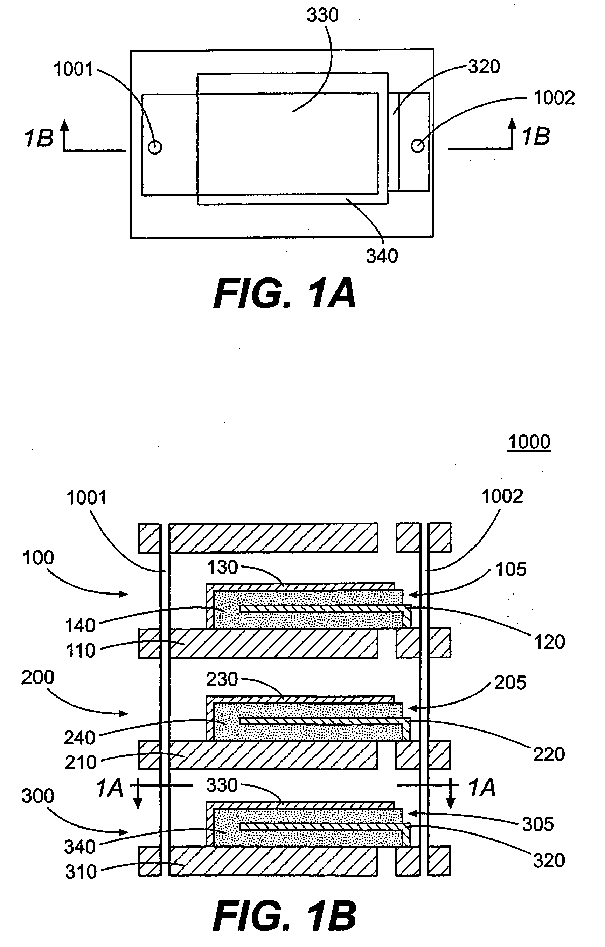

FIG. 1A is a plan view of a portion of a first embodiment of a printed wiring board 1000, seen from the perspective of line 1A-1A in FIG. 1B. FIG. 1B is a sectional view in front elevation of the printed wiring board 1000, taken on line 1B-1B in FIG. 1A.

As shown in FIG. 1B, the printed wiring board 1000 includes a plurality of stacked innerlayer panels 100, 200, 300. The innerlayer panel 100 includes a capacitor 105, the innerlayer panel 200 includes a capacitor 205, and the innerlayer panel 300 includes a capacitor 305. According to this embodiment, the capacitors 105, 205, 305 are connected in parallel by a first circuit conductor 1001 and a second circuit conductor 1002.

The capacitor 105 of the innerlayer panel 100 comprises a first electrode 110, a second electrode 120, a third electrode 130, and a dielectric 140. The dielectric 140 separates the second electrode 120 from the first and third electrodes 110, 130, and is in the form of a two-layer dielectric. Similarly, the capacitor 205 has a first electrode 210, a second electrode 220, a third electrode 230, and a two-layer dielectric 240, and the capacitor 305 has a first electrode 310, a second electrode 320, a third electrode 330, and a two-layer dielectric 340. The first electrodes 110, 210, 310 can be formed, for example, from foils that the capacitors 105, 205, 305 are subsequently formed over. The capacitors 105, 205, 305 can therefore be of a fired-on-foil type. The capacitors 105, 205, 305 may also be of a cured polymeric type.

In FIGS. 1A and 1B, the first circuit conductor 1001 electrically connects the first and third electrodes 110, 130 of the capacitor 105 to the first and third electrodes 210, 230 of the capacitor 205, and to the first and third electrodes 310, 330 of the capacitor 305. The second circuit conductor 1002 electrically connects the second electrodes 120, 220, 320 of the capacitors 105, 205, 305, respectively. In this way, the capacitors 105, 205, 305 are connected in parallel.

The printed wiring board 1000 is illustrated as having three innerlayer panels 100, 200, 300. However, two, or four or more innerlayer panels can be included in a printed wiring board according to the above embodiment. Differing combinations of innerlayer panels can include multiple capacitors connected in parallel. The innerlayer panels 100, 200, 300 can be connected by layers of laminate material (not shown in FIG. 1B). The first and second circuit conductors 1001, 1002 can be formed through the laminate materials. Methods of forming the innerlayer panels and the printed wiring board 1000, including the formation of laminate material layers, are discussed in detail below.

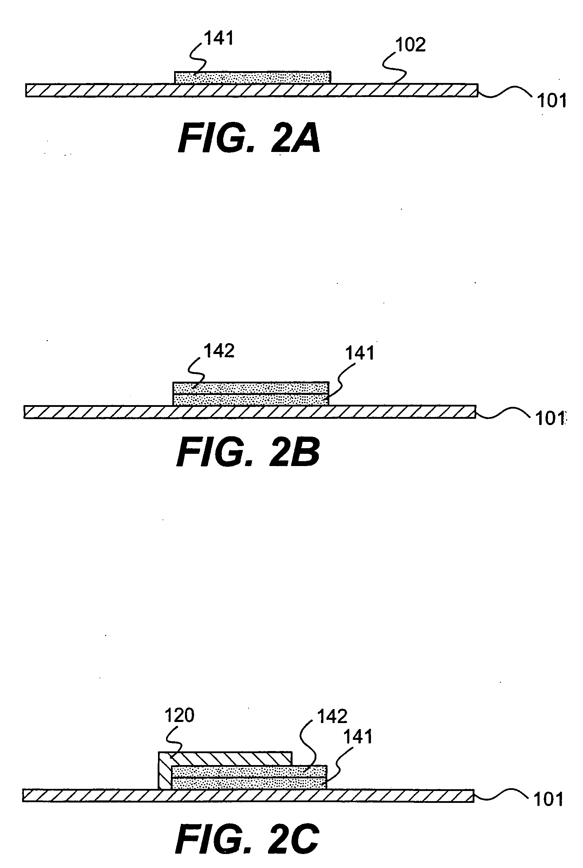

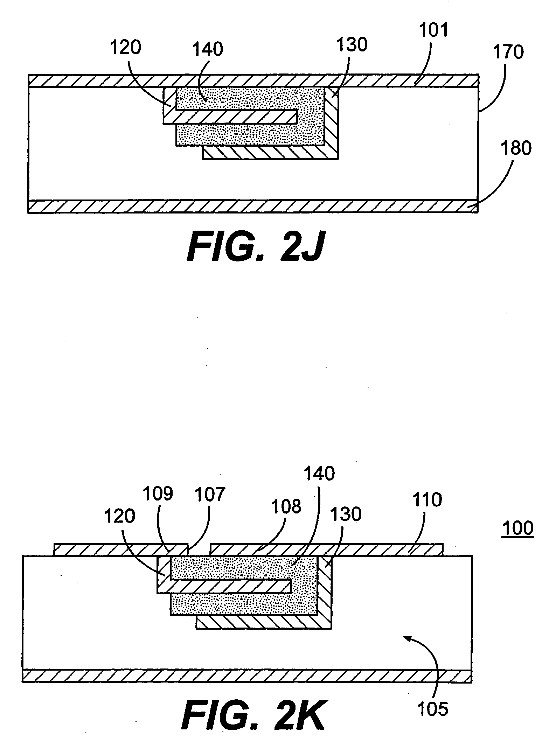

FIGS. 2A-2K illustrate a method of making an embodiment of the innerlayer panel 100 suitable for use in the printed wiring board 1000 illustrated above. The embodiment discussed below is a fired-on-foil embodiment where capacitor layers are co-fired.

FIG. 2A is a front elevational view of a first stage of manufacturing of the innerlayer panel 100. In FIG. 2A, a metallic foil 101 is provided. The foil 101 may be of a type generally available in the industry. For example, the foil 101 may be copper, copper-invar-copper, invar, nickel, nickel-coated copper, or other metals that have melting points in excess of the firing temperature for thick-film pastes. Preferred foils include foils comprised of untreated copper, but reverse-treated copper foils, double-treated copper foils, and other predominantly copper foils commonly used in the multilayer printed circuit board industry can also be used. The thickness of the foil 101 may be in the range of, for example, about 1-100 microns, preferably 3-75 microns, and most preferably 12-36 microns, corresponding to between about 1/3 oz and 1 oz copper foil.

The foil 101 may be pretreated, for example, by applying and firing an underprint 102. The underprint 102 is a relatively thin layer applied to a component-side surface of the foil 101. In FIG. 2A, the underprint 102 is indicated as a surface coating on the foil 101. The underprint 102 adheres well to the metal foil 101 and to layers deposited over the underprint 102. The underprint 102 may be formed, for example, from a paste applied to the foil 101, which is then fired at a temperature below the melting point of the foil 101. The paste may be printed as an open coating over the entire surface of the foil 101, or printed on selected areas of the foil 101.

Referring to FIG. 2A, a dielectric material is screen-printed onto the pretreated foil 101, forming a first dielectric layer 141. The dielectric material may be, for example, a thick-film dielectric ink. The dielectric ink may be formed of, for example, a paste. The first dielectric layer 141 is then dried.

In FIG. 2B, a second dielectric layer 142 is then applied, and dried. In an alternative embodiment, a single layer of dielectric material may be deposited through a mesh screen that is coarser than the mesh screen used to form the two separate layers 141, 142. The coarser mesh screen provides an equivalent thickness in one printing.

In FIG. 2C, a second electrode 120 is formed over the second dielectric layer 142 and dried. The second electrode 120 may be formed by, for example, screen-printing a thick-film metallic ink. In general, the surface area of the dielectric layer 142, when viewed from a top plan perspective should be larger than that of the second electrode 120. The second electrode 120 is formed to extend over one end of the layers 141, 142 and to contact the foil 101.

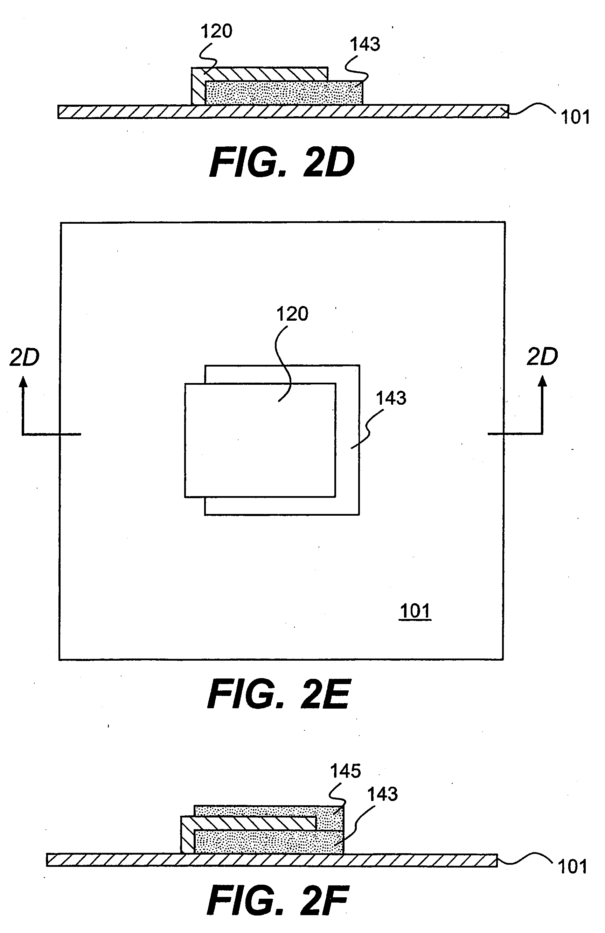

The first dielectric layer 141, the second dielectric layer 142, and the second electrode 120 are then co-fired. "Co-fired" means that the layers 141, 142 are not fired prior to forming the second electrode 120. The post-fired structure is shown in front elevation in FIG. 2D and in plan view in FIG. 2E. A dielectric layer 143 results from the co-firing step. The thick-film dielectric layers 141, 142 may be formed of, for example, a high dielectric constant (or, "high K") functional phase such as, for example, barium titanate and a dielectric property-modifying additive such as, for example, zirconium dioxide, mixed with a glass-ceramic frit phase. During co-firing, the glass-ceramic frit phase softens, wets the functional and additive phases and coalesces to create a dispersion of the functional phase and the modifying additive in a glass-ceramic matrix. At the same time, the second electrode 120 and the foil 101 are wetted by the softened glass-ceramic frit phase and sinter together. The second electrode 120 and the foil 101 have a strong bond to the high K dielectric 143 that results from the co-firing.

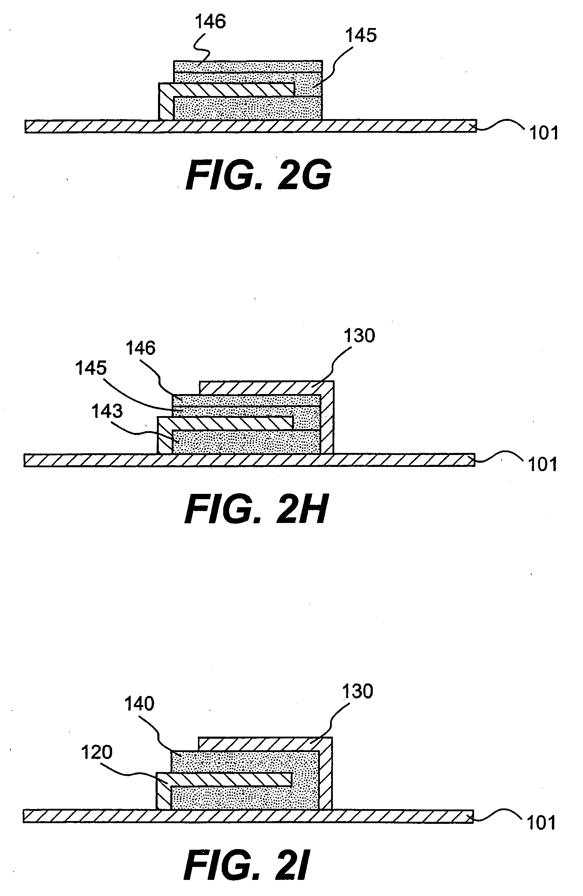

In FIG. 2F, a third layer of dielectric material is screen-printed onto the pretreated foil 101, forming a third dielectric layer 145. The third dielectric layer 145 is then dried. In FIG. 2G, a fourth dielectric layer 146 is applied and dried. A single layer of dielectric material alternatively may be formed using a coarse mesh screen during screen printing.

In FIG. 2H, a third electrode 130 is formed over the fourth dielectric layer 146 and dried. The third electrode 130 extends over the edges of the dielectric layers to contact the foil 101. The resulting article is then fired. The layers 145, 146, and the third electrode 130 may be co-fired, meaning that the layers 145 and 146 are not fired prior to firing the third electrode 130. FIG. 2I illustrates the resulting article after co-firing, with the resulting two-layer dielectric 140. After co-firing, the two-layer dielectric 140 securely adheres to the second and third electrodes 120, 130 and to the foil 101, and the resulting article is crack-free.

As an alternative to two separate firing steps as discussed with reference to FIGS. 2D and 2I, a single co-firing can be performed after forming the third electrode 130. A single co-firing is advantageous in that production costs are reduced. Two separate firings, however, allow for inspection of the second electrode 120 for defects, such as cracks and printing alignment problems, after the first firing.

In FIG. 2J, the structure is inverted and laminated. For example, the component-side face of the foil 101 can be laminated to a laminate dielectric material 170 and to another conductive foil 180. The lamination can be performed, for example, using FR4 prepreg in standard printing wiring board processes. In one embodiment, type 106 epoxy prepreg may be used. Suitable lamination conditions are, for example, 185°C at 208 psig for 1 hour in a vacuum chamber evacuated to about 28 inches of mercury. A silicone rubber press pad and a smooth PTFE-filled glass release sheet may be in contact with the foils 101 and 180 to prevent the epoxy from gluing the lamination plates together. The foil 180 can be used, for example, to create connection circuitry. The dielectric prepreg and laminate materials can be any type of dielectric material such as, for example, standard epoxy, high Tg epoxy, polyimide, polytetrafluoroethylene, cyanate ester resins, filled resin systems, BT epoxy, and other resins and laminates that provide insulation between circuit layers.

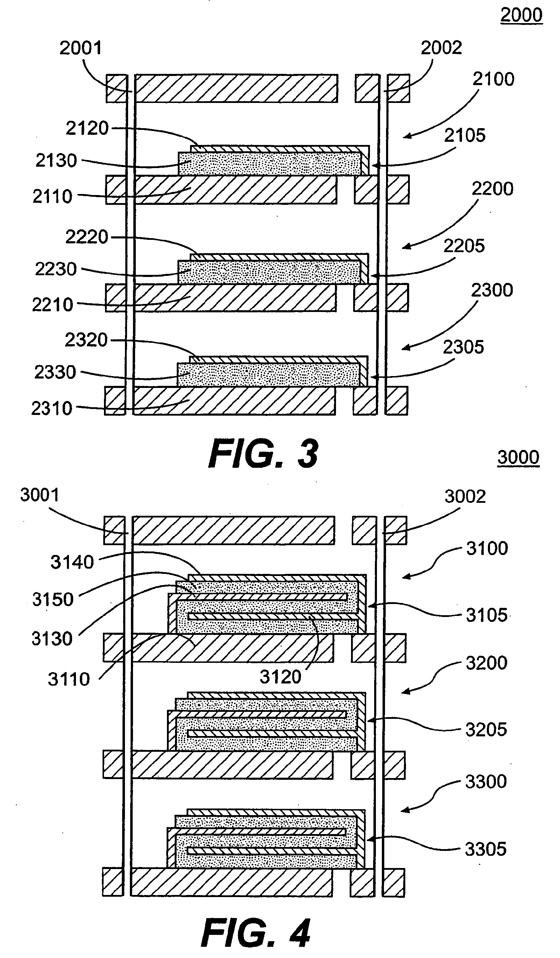

Referring to FIG. 2K, after lamination, a photo-resist is applied to the foils 101, 180 and the foils are 101, 180 are imaged, etched and stripped using standard printing wiring board processing conditions. The foil 180 can be circuitized by the etching process. For simplicity of illustration, circuitry formed from the foil 180 is not illustrated in FIGS. 3 and 4. Circuitry formed from the foil 180 would be located in FIG. 3 between some or all of the capacitors 2105, 2205 and 2305, for example, and in FIG. 4 between some or all of the capacitors 3105, 3205 and 3305.

The first electrode 110 results from the etching of the foil 101. The etching creates a trench 107 in the foil 101 (reference number 101 is not used in FIG. 2K), which breaks electrical contact of the first and third electrodes 110, 130 from the second electrode 120. A portion 108 of the foil 101 forms the first electrode 110, and a portion 109 of the foil 101 is electrically connected to the second electrode 120. The electrodes 110, 120, 130, and the two-layer dielectric 140 form the capacitor 105.

FIG. 2K illustrates the innerlayer panel 100 before integration of the innerlayer panel 100 into the printed wiring board 1000 illustrated in FIG. 1B. The printed wiring board 1000 can be formed from multiple stacked innerlayer panels by, for example, lamination processes. The innerlayer panels 200, 300 can be laminated together in one or more conventional lamination pressings. The innerlayer panels can be bonded together using, for example, dielectric prepregs. The printed wiring board 1000 may be laminated in multiple stages. For example, subassemblies of innerlayer panels may be processed and laminated, and one or more subassemblies can subsequently be stacked and laminated together to form the finished printed wiring board 1000.

Each of the innerlayer panels can have a different design, including differing arrangements of circuit elements. The term "innerlayer panel" does not imply that the panels must be sandwiched in the interior of the printed wiring board 1000, and the innerlayer panels can also be located on, for example, the outside layers of the printed wiring board 1000.

As illustrated in FIG. 1B, the innerlayer panels 100, 200, 300 are in a stacked arrangement. The innerlayer panels 100, 200, 300 of the printed wiring board 1000 are connected in parallel by the first and second circuit conductors 1001, 1002. The first and second circuit conductors 1001, 1002 can be formed as conductive vias, for example, by laser or mechanical drilling through the stacked and laminated innerlayer panels 100, 200, 300. The holes formed by drilling are then plated with a conductive material. The resulting conductive vias 1001, 1002, which extend through the entire printed wiring board 1000 shown in FIG. 1B, are typically referred to as "plated through-holes." Plated through-hole type vias are usually formed after all of the innerlayer panels of a printed wiring board have been laminated together. In FIG. 1B, and in other figures in this specification, plated through-holes are illustrated as terminating at either end of innerlayer panels. A plated through-hole will, however, be a continuous plated via extending through multiple innerlayer panels.

The conductors 1001, 1002 are illustrated as plated through-holes to illustrate the connection of multiple innerlayer panels in parallel. However, if the printed wiring board 1000 includes additional layers, additional circuit conductors (not shown) in other parts of the printed wiring board 1000 could extend through subassemblies of innerlayer panels or through individual innerlayer panels. Via circuit conductors extending through only a part of the printed wiring board 1000 are commonly referred to as "buried vias." Buried vias are typically drilled and plated through a subassembly of innerlayer panels before the subassembly of innerlayer panels is incorporated into a printed wiring board. A small diameter conductive via formed on one or both sides of an innerlayer panel is commonly referred to as a "microvia," and may be used, for example, to terminate a capacitor within an innerlayer panel.

After all interconnections have been formed and all subassemblies of innerlayer panels or individual innerlayer panels have been laminated together, the printed wiring board 1000 is complete. In FIG. 1B, the printed wiring board 1000 is illustrated as comprising the innerlayer panels 100, 200, 300 in a stacked configuration, laminated (laminate materials not shown) and connected by the circuit conductors 1001, 1002. Any number of innerlayer panels, however, may be included in a printed wiring board according to the present embodiments.

FIG. 3 illustrates an alternative embodiment of a printed wiring board 2000 having capacitors connected in parallel. FIG. 3 is a schematic sectional view in front elevation of the printed wiring board 2000. The printed wiring board 2000 includes a plurality of stacked innerlayer panels 2100, 2200, 2300. The innerlayer panel 2100 includes a capacitor 2105, the innerlayer panel 2200 includes a capacitor 2205, and the innerlayer panel 2300 includes a capacitor 2305. According to this embodiment, the capacitors 2105, 2205, 2305 are connected in parallel by a first circuit conductor 2001 and a second circuit conductor 2002.

The capacitor 2105 of the innerlayer panel 2100 comprises a first electrode 2110, a second electrode 2120, and a dielectric 2130. The dielectric 2130 separates the second electrode 2120 from the first electrode 2110, and is in the form of a single-layer dielectric. Similarly, the capacitor 2205 has a first electrode 2210, a second electrode 2220 and a dielectric 2230, and the capacitor 2305 has a first electrode 2310, a second electrode 2320, and a dielectric 2330. The first electrodes 2110, 2210, 2310 can be formed, for example, from foils that the capacitors 2105, 2205, 2305 are subsequently built upon, and the capacitors 2105, 2205, 2305 can therefore be of a fired-on-foil type.

The printed wiring board 2000 can have a shape, when viewed from a top plan perspective, similar to the printed wiring board 1000 illustrated in FIG. 1A, or other shapes can be used. The printed wiring board 2000 can be manufactured in a manner similar to the printed wiring board 1000, except that the dielectrics 2130, 2230 and 2330 are in the form of single layers, and the capacitors 2105, 2205, 2305 each include only two electrodes.

In FIG. 3, a first circuit conductor 2001 electrically connects to the first electrode 2110 of the capacitor 2105 and to the first electrodes 2210 and 2310. The second circuit conductor 2002 connects to the second electrodes 2120, 2220, 2320. In this way, the capacitors 2105, 2205, 2305 are connected in parallel. The innerlayer panels 2100, 2200, 2300 can be connected together using, for example, lamination pressings.

FIG. 4 illustrates another alternative embodiment of a printed wiring board 3000 having capacitors connected in parallel. FIG. 4 is a schematic sectional view in front elevation of the printed wiring board 3000. The printed wiring board 3000 includes a plurality of stacked innerlayer panels 3100, 3200, 3300. The innerlayer panel 3100 includes a capacitor 3105, the innerlayer panel 3200 includes a capacitor 3205, and the innerlayer panel 3300 includes a capacitor 3305. According to this embodiment, the capacitors 3105, 3205, 3305 are connected in parallel by a first circuit conductor 3001 and a second circuit conductor 3002.

The capacitor 3105 of the innerlayer panel 3100 comprises a first electrode 3110, a second electrode 3120, a third electrode 3130, a fourth electrode 3140, and a dielectric 3150. The dielectric 3150 separates the first and third electrodes 3110, 3130 from the second and fourth electrodes 3120, 3140, and is in the form of a three-layer dielectric. The capacitors 3205 and 3305 may be constructed similarly to the capacitor 3105.

The first circuit conductor 3001 electrically connects the first and third electrodes of the capacitors 3105, 3205, 3305, and the second circuit conductor 3002 electrically connects the second and fourth electrodes. In this way, the capacitors 3105, 3205, 3305 are connected in parallel.

The printed wiring board 3000 can have a shape, when viewed from a top plan perspective, similar to the printed wiring board 1000 illustrated in FIG. 1A, or other shapes may be used. The printed wiring board 3000 can be manufactured in a manner similar to the printed wiring board 1000, except that the dielectric 3150 is in the form of a three-layer dielectric, and an additional, fourth electrode 3140 is present. In this embodiment, an additional layer of dielectric is formed over the third electrode 3130, and the fourth electrode 3140 is then formed over the additional layer of dielectric. The innerlayer panels 3100, 3200, 3300 can be connected together using, for example, lamination pressings.

The printed wiring board embodiments 1000, 2000, 3000 discussed above with reference to FIGS. 1A-4 provide high capacitances in relatively small x-y surface areas. These embodiments are particularly useful when the x-y surface area in a device is limited, while the limitations on the thickness or z dimension of the device are less restrictive. A printed wiring board constructed according to the above embodiments can include any number of innerlayer panels stacked and connected in parallel, thereby providing high capacitance within a small x-y surface area. Additional combinations of different types of innerlayer panels may be used in addition to or as an alternative to innerlayer panels having capacitors connected in parallel.

The printed wiring board embodiments discussed above with reference to FIGS. 1A-4 are described as formed by fired-on-foil processes, which can involve co-firing of one or more capacitor layers. Other methods and materials of construction, however, can be used to form the printed wiring boards 1000, 2000, 3000. For example, polymeric capacitors can also be formed in innerlayer panels and connected in parallel as in the embodiments described above. Polymeric capacitors can be formed, for example, in a manner similar to the above embodiments, except that deposited or printed layers are cured, not fired.

Suitable materials for the paste used to form polymeric conductive layers include, for example, polymer thick-film copper pastes, silver polymer thick-film pastes, which may include copper or silver powders dispersed into an organic vehicle. The organic vehicle can be an epoxy solution or other solutions based on other resins. A commercially available polymer conductive layer is CB200 available from E.I. du Pont de Nemours and Company.

Suitable materials for the paste used to form polymer dielectric layers include polymer thick-film dielectric pastes. Polymer thick-film dielectric pastes are generally high dielectric constant materials, such as, for example, barium titanate, dispersed into an organic vehicle such as an epoxy resin. A commercially available high dielectric constant polymeric dielectric layer is 7153 thick-film dielectric available from E. I. du Pont de Nemours and Company. Curing of the conductive and dielectric layers can be performed at, for example, about 150°C.

The conductive layers discussed in this specification may also be formed by, for example, electrodeposition processes or evaporation processes. Electrodeposition processes or evaporation processes can be used to form, for example, metallic conductive layers. The dielectric layers may alternatively be formed by, for example, thin film chemical solution deposition, sputtering or chemical anodizing of a previously applied metal such as tantalum.

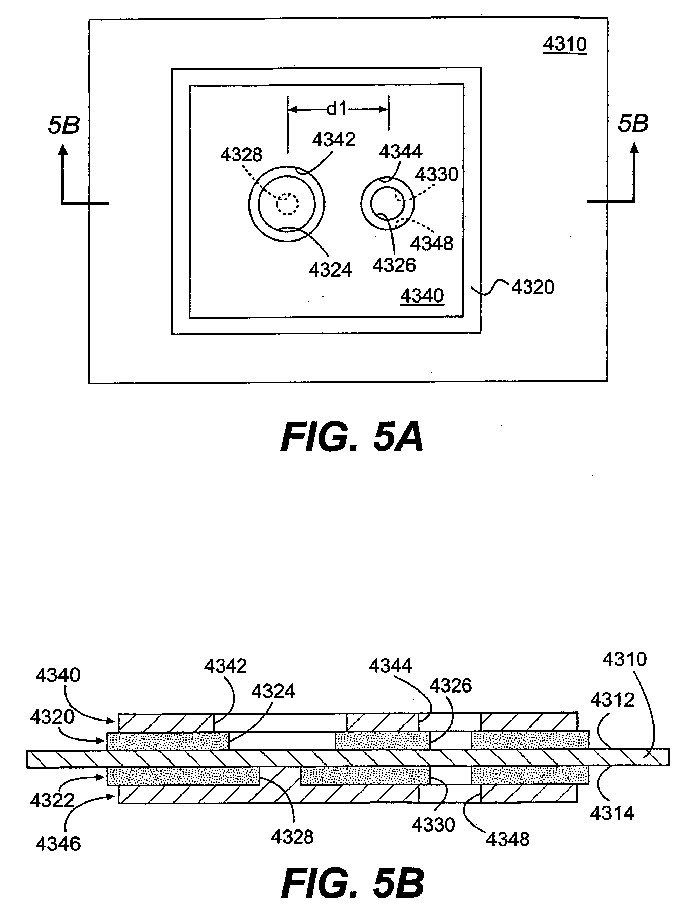

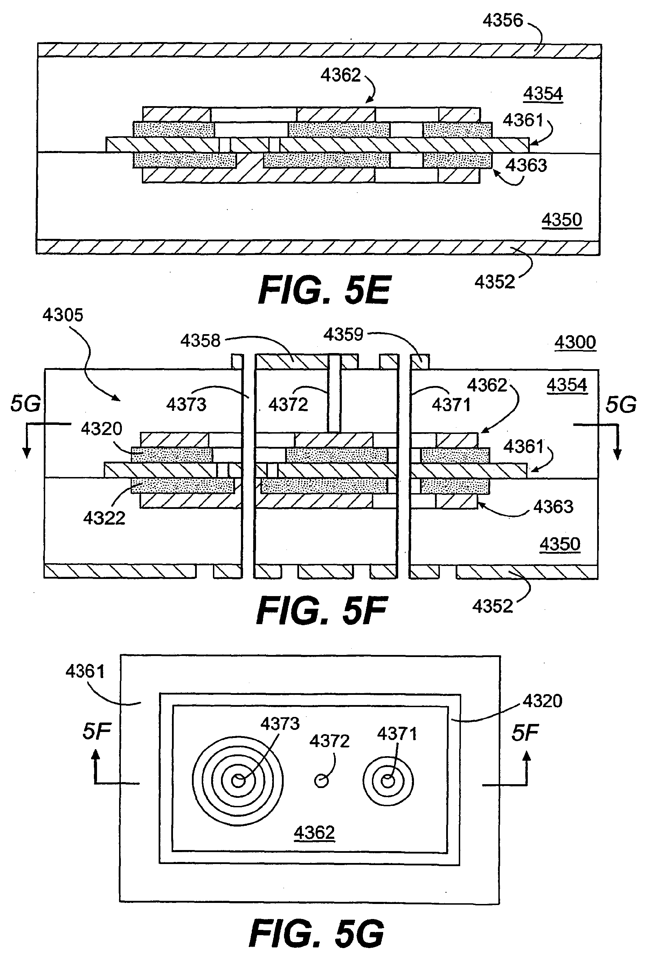

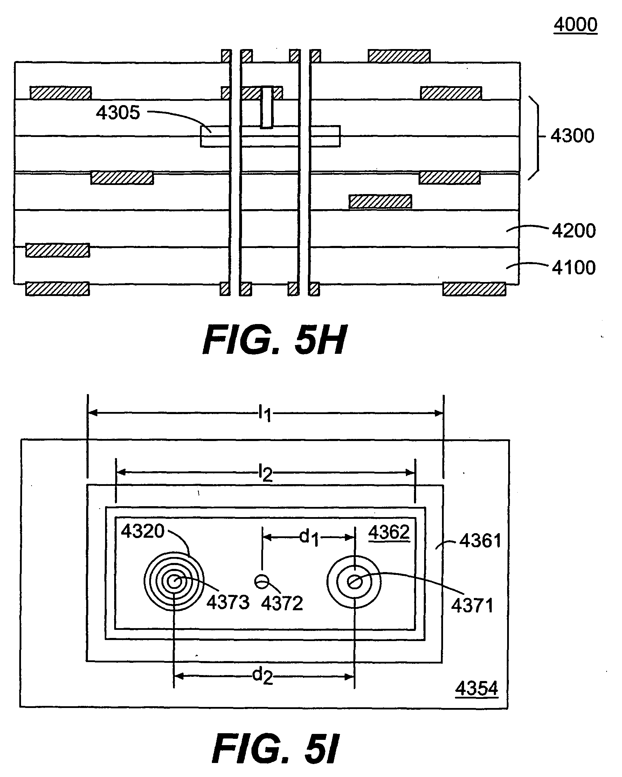

FIGS. 5A-5H illustrate a general method of manufacturing a printed wiring board 4000 having innerlayer panels. The innerlayer panels may include capacitors having electrodes formed on either side of a foil electrode. The finished printed wiring board 4000 is illustrated in sectional view in FIG. 5H. In FIG. 5H, the opposite electrodes in the capacitor 4305 are connected to power and ground 4441 and 4442, respectively. Alternatively they can be connected to other circuit elements. FIG. 5F illustrates a completed innerlayer panel 4300 in an isolated sectional view. A single capacitor 4305 is formed in the innerlayer panel 4300 described below. However, the printed wiring board 4000 can include a large number of individual capacitors of differing type and arranged in various ways in the printed wiring board 4000.

FIGS. 5A and 5B illustrate a first stage of manufacture of the innerlayer panel 4300. The innerlayer panel 4300 is to be incorporated in the printed wiring board 4000. FIG. 5A is a top plan view, and FIG. 5B is a sectional view from FIG. 5A taken on section line 5B-5B. In FIGS. 5A and 5B, a metallic foil 4310 is provided. The foil 4310 may have a large surface area and can be used to produce a large number of passive components, including capacitors. The foil 4310 may be of a type generally available in the industry. For example, the foil 4310 may be copper, copper-invar-copper, invar, nickel, nickel-coated copper, or other metals that have melting points in excess of the firing temperature for thick-film pastes. Preferred foils include foils comprised predominantly of untreated copper. The thickness of the foil 4310 may be in the range of, for example, about 1-100 microns, preferably 3-75 microns, and most preferably 12-36 microns, corresponding to between about 1/3 oz and 1 oz copper foil.

The foil 4310 may be pretreated by applying an underprint 4312 to a first side of the foil 4310 and an underprint 4314 to a second side of the foil 4310. The underprints 4312, 4314 are relatively thin layers applied to the component-side surfaces of the foil 4310. In FIG. 5B, the underprints 4312, 4314 are indicated as surface coatings on the foil 4310. The u nderprints 4312, 4314 adhere well to the metal foil 4310 and to layers deposited over the underprints 4312, 4314. The underprints 4312, 4314 may be formed, for example, from a paste applied to the foil 4310 that is fired at a temperature below the melting point of the foil 4310. The paste may be printed as an open coating over the entire surfaces of the foil 4310, or printed on selected areas of the foil 4310.

Referring to FIG. 5B, dielectric material is screen-printed onto the first side of the pretreated foil 4310, forming a first dielectric layer 4320. The dielectric material may be, for example, a thick-film dielectric ink. The dielectric ink may be formed of, for example, a paste.

The first dielectric layer 4320 can be formed from, for example, two separate screen printings of dielectric material. If two separate screen printings are performed, a first dielectric layer is printed and dried, and a second dielectric layer which may be of the same thickness and shape is printed over the first dielectric layer and dried. Alternatively, the dielectric layer 4320 can be formed by a single printing of dielectric material, which is subsequently dried. When a single printing of dielectric material is used to form the first dielectric layer 4320, a single layer of dielectric material is deposited through a coarse mesh screen to provide an equivalent thickness dielectric layer. A first aperture (or through-hole) 4324 and a second aperture 4326 are included in the first dielectric layer 4320 during forming.

A first conductive layer 4340 is next formed over the first dielectric layer 4320 and dried. The first conductive layer 4340 can be formed by, for example, screen-printing a thick-film metallic ink. The first conductive layer 4340 is formed with a first aperture 4342 aligned over the first aperture 4324, and a second aperture 4344 aligned over the second aperture 4326. The first conductive layer 4340 can be formed by, for example, screen-printing. The resulting article is then fired.

In the embodiment illustrated in FIGS. 5A and 5B, the apertures 4324, 4326, 4342, 4344, are circular, as shown in the top plan view of FIG. 5A. Other shapes, however, are possible.

The screen printing process is repeated to build layers on the second side of the foil 4310. The subsequent build steps result in a second dielectric layer 4322 with apertures 4328 and 4330, and a second conductive layer 4346 with an aperture 4348. The resulting article is then fired.

The post-fired article is shown in FIGS. 5A and 5B. Firing the dielectric layers 4320, 4322 and the respective conductive layers 4340, 4346 at the same time may be considered co-firing the dielectric and conductive layers. The thick-film dielectric layers 4320, 4322, may be formed of, for example, a high dielectric constant functional phase and a dielectric property-modifying additive, mixed with a glass-ceramic frit phase. In general, the surface areas, or footprints, of the dielectrics 4320, 4322 should be larger than those of the conductive layers 4340, 4346. This is illustrated for the dielectric 4320 in the plan view FIG. 5A.

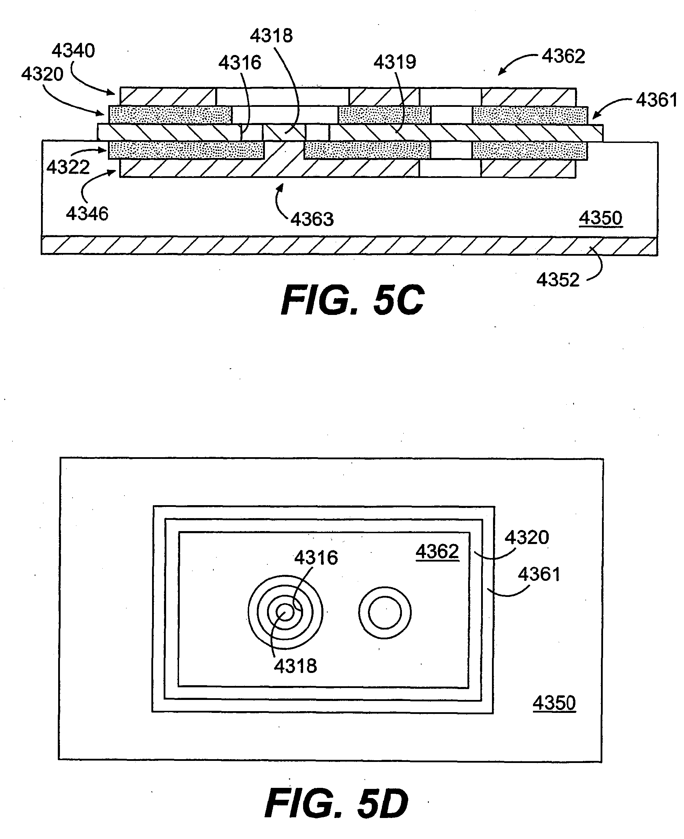

Referring to FIGS. 5C and 5D, the resulting article, on a second side of the foil 4310 (reference number 4310 is not used in FIGS. 5C and 5D), is laminated to a laminate material 4350. The lamination can be performed, for example, using FR4 prepreg in standard printing wiring board processes. In one embodiment, type 106 epoxy prepreg may be used. A conductive foil 4352 may be applied to the laminate material 4350 to provide, for example, a surface for creating connection circuitry. The dielectric prepreg and laminate materials can be any type of dielectric material such as, for example, standard epoxy, high Tg epoxy, polyimide, polytetrafluoroethylene, cyanate ester resins, filled resin systems, BT epoxy, and other resins and laminates that provide insulation between circuit layers.

After lamination, a photo-resist is applied to the foil 4310 and the foil 4310 is imaged, etched and stripped using standard printing wiring board processing. The foil 4352 may also be etched at this time, for example, to provide circuitry. FIGS. 5C and 5D show the resulting article after etching of the foil 4310. Etching the foil 4310 results in a trench 4316 that isolates a first portion 4318 of the foil 4310 from a second portion 4319, thereby isolating the second conductive layer 4346 from the portion 4319.

After the etching process, a first electrode 4361 results from the remainder portion 4319 of the foil 4310. A second electrode 4362 corresponds to the conductive layer 4340. A third electrode 4363 is formed from the conductive layer 4346, and is connected to the portion 4318 of the foil 4310.

In FIG. 5E, the resulting article is laminated on a first side of the first foil electrode 4361 to a second laminate material 4354. A foil 4356 may be applied to the second laminate material 4354.

FIGS. 5F and 5G illustrate the finished innerlayer panel 4300, having a capacitor 4305. FIG. 5F is a sectional view taken along line 5F-5F in FIG. 5G. Referring to FIGS. 5E and 5F, a photo-resist is applied to the foil 4356 and the foil 4356 is imaged, etched and stripped. At this time, it is preferable to form a second microvia circuit conductor 4372. First and third via circuit conductors 4371 and 4373 may also be formed at this stage, but can alternatively be formed as through-hole vias after the innerlayer panel 4300 has been incorporated into a multilayer printed circuit board. Other types of circuit conductors may be used instead of through-hole vias. For example, a conductive connection to a peripheral edge of the first foil electrode 4361 can be used as an alternative to the first circuit conductor 4371.

Referring to FIGS. 5F and 5G, etching of the foil 4356 results in circuitry, or a "lead" 4358 that electrically connects the second circuit conductor 4372 to the third circuit conductor 4373, and accordingly electrically connects the second electrode 4362 to the third electrode 4363. Circuitry 4359 on the laminate material 4354 electrically connects to the first circuit conductor 4371, and to the first electrode 4361. The circuit conductors 4371, 4372, 4373 may be formed, for example, by drilling and subsequent plating with a conductive metal. The drilling can be, for example, laser drilling to form the second circuit conductor 4372. Mechanical drilling may be preferred to form the circuit conductors 4371, 4373 if they are of the through-hole type.

As shown in the FIG. 5F, the completed innerlayer panel 4300 includes the capacitor 4305 with electrodes 4361, 4362, 4363. The second and third electrodes 4362, 4363 are located on either side of the first foil electrode 4361.

FIG. 5H is a schematic sectional view of the completed printed wiring board 4000. The printed wiring board 4000 includes innerlayer panels 4100, 4200 and the innerlayer panel 4300, and may include additional innerlayer panels. One or more of the innerlayer panels 4100, 4200 may include capacitors with electrodes disposed on either side of an electrode, or capacitors having other designs. Additional interconnect circuitry, other passive components, or active components, may also be included in the printed wiring board 4000.

FIG. 51 is a sectional view taken along line 5G-5G in FIG. 5F, and is similar to FIG. 5G. FIG. 5I is provided to illustrate the relative locations of the capacitor terminations in the innerlayer panel 4300. As shown in FIGS. 5F and 5I, a termination of the third electrode 4363 is located at a through-hole aperture of the dielectric layer 4322, where the third circuit conductor 4373 is electrically coupled to the third electrode 4363. The termination of the first electrode 4361 is located where the first circuit conductor 4371 is electrically coupled to the first electrode 4361. The termination of the second electrode 4362 is located where the second circuit conductor 4372 is electrically coupled to the second electrode 4362. Referring specifically to FIG. 51, the terminations of the electrodes 4361, 4362, 4363 are located within the plan surface areas, or "footprints" of the respective electrodes 4361, 4362, 4363.

The spacing between the terminations defined by the circuit conductors 4371 and 4373 of the capacitor 4305 is *d*_{*2*}*.* A width of the first electrode 4361 is *I*_{*1*}*,* a width of the second electrode 4362 is *I*_{*2*}*,* and a width of the third electrode 4363 (not shown in FIG. 51) is *I*_{*3*}*.* The width *I*_{*3*} can be approximately equal to /_{*2*}. The spacing d₂ can be much smaller than any of the widths *I*_{*1*}, *l*_{*2*}*,* /₃. For example, the spacing *d*₂ may be less than two-thirds, or less than half of any of the widths *I*_{*1*}*, I*_{*2*}*, I*_{*3*}*.*

According to the above embodiment, the terminations located within the electrode footprints may be spaced relatively closely to one another, reducing the contribution to circuit inductance by the capacitor 4305.

### EXAMPLE 1

Referring to FIGS. 5A-5H, a specific embodiment of the innerlayer panel 4300 and a printed wiring board 4000 will now be described. In this specific embodiment, the foil 4310 is a copper foil. The type of copper foil 4310 can be any commercial grade of copper foil used in the printed wiring board industry, and is in the range of 1/3 oz copper foil (approximately 12 microns thickness) to 1 oz copper foil (approximately 36 microns thickness). The copper foil 4310 is pretreated by applying a copper underprint paste over selected areas of the foil 4310. The resulting article is then fired in nitrogen at 900°C for 10 minutes at peak temperature, with a total cycle time of approximately 1 hour, forming the underprint 4312. The process is repeated to form the underprint 4314.

In FIGS. 5A and 5B, a thick-film dielectric ink is screen-printed onto one side of the pretreated copper foil 4310 through a 325 mesh screen. The dielectric layer 4320 is formed by two screen printings, each screen printing leaving a dielectric layer of a printed thickness of approximately 12-15 microns. The screen printed dielectric layer 4320 is dried at 125°C for approximately 10 minutes. The thick-film dielectric ink includes a barium titanate component, a zirconium oxide component, and a glass-ceramic phase. The spacing *d*_{*2*} (shown in FIG. 5I) of the apertures 4324, 4326 is greater than about 77 mils. The diameters of the apertures 4324, 4326 are approximately 26 mils and 16 mils respectively.

A thick-film copper electrode ink layer 4340 is printed through 325 mesh screens onto the dielectric layer 4320 and dried at 125°C for approximately 10 minutes. The size of the dielectric layer 4320 is approximately 10 mils larger around its peripheral edge than the conductive layer 4340. The diameters of the apertures 4342 and 4344 are approximately 20 mils greater than the apertures 4324 and 4326, respectively. The thickness of the printed conductive layer 4340 is in the range of 3 to 15 microns. The resulting structure is co-fired to 900°C for 10 minutes at peak temperature using a thick-film nitrogen profile. The nitrogen profile includes less than 50 ppm oxygen in the burnout zone, and 2-10 ppm oxygen in the firing zone, with a total cycle time of 1 hour. The printing and firing procedure is repeated on the second side of the foil 4310 to form the layers 4322, 4346. The apertures 4328 and 4330 are approximately 16 mils (0.4 mm) in diameter and are positioned concentrically with the apertures 4324 and 4326 on the opposite side of the foil 4310. The aperture 4348 is approximately 36 mils (0.9 mm) in diameter.

Referring to FIG. 5C, a printed wiring board substrate laminate material 4350 of FR-4 is laminated to the second side of the foil 4310. A copper foil 4352 is formed over the laminate material 4350. The lamination conditions are 185°C at 208 psig (1434 kPa gage) for 1 hour in a vacuum chamber evacuated to 28 inches of mercury (95 kPa). A silicone rubber press pad and a smooth PTFE filled glass release sheet are in contact with the foil 4310 to prevent the epoxy from gluing the lamination plates together. The foil 4310 is imaged, etched and stripped. The trench 4316 has an inside diameter of a little more than 16 mils (0.4 mm) and an outside diameter of a little less than 26 mils (0.66 mm).

Referring to FIG. 5E, a printed wiring board substrate laminate material 4354 of FR-4 is laminated to the article resulting from the previous lamination, on the first side of the second electrode 4362. A copper foil 4356 is formed over the laminate material 4354.

Referring to FIGS. 5F and 5G, the foil 4356 is imaged, etched and stripped to form the circuitry 4358, 4359. The second circuit conductor 4372 is then formed by laser drilling an 8-16 mils (0.2 - 0.4 mm) diameter hole to connect to the second electrode 4362, and the hole is then plated with copper to form a conductive microvia.

The resultant article is then laminated into a multilayer printed wiring board, as shown in FIG. 5H, and circuit conductor vias 4371 and 4373 are mechanically drilled and plated to form conductive through-holes that connect to the electrodes 4361 and 4363, respectively and the power and ground planes of the printed wiring board 4000.

In this example, the thick-film dielectric material had the following composition:

| | |
|---|---|
| Barium titanate powder | 64.18% |
| Zirconium oxide powder | 3.78 % |
| Glass A | 11.63% |
| Ethyl cellulose | 0.86% |
| Texanol | 18.21% |
| Barium nitrate powder | 0.84% |
| Phosphate wetting agent | 0.5 %. |
| | |
| Glass A comprised: | |
| | |
| Germanium oxide | 21.5% |
| Lead tetraoxide | 78.5 %. |

The Glass A composition corresponded to Pb₅Ge₃O₁₁, which precipitates out during the firing, and has a dielectric constant of approximately 70-150. The fired dielectric has a dielectric constant of approximately 1000. The thick-film copper electrode ink comprised:

| | |
|---|---|
| Copper powder | 55.1% |
| Glass A | 1.6% |
| Cuprous oxide powder | 5.6 % |
| Ethyl cellulose T-200 | 1.7% |
| Texanol | 36.0 %. |

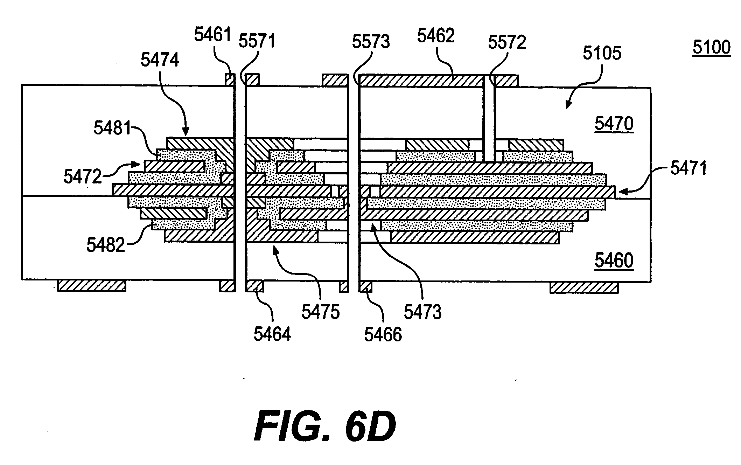

FIGS. 6A-6D illustrate a method of manufacturing a second embodiment of an innerlayer panel 5100 (FIG. 6D) having a capacitor 5105 with multiple electrodes disposed on either side of a foil electrode. The innerlayer panel 5100 can be incorporated into a printed wiring board, such as, for example, the printed wiring board embodiments 1000, 2000, 3000, 4000 discussed above. The finished innerlayer panel 5100, illustrated in FIG. 6D, is a five-electrode capacitor embodiment having two electrodes on both sides of a foil electrode. The capacitor 5105 also includes four layers of dielectric, and provides a high capacitance density.

FIG. 6A is sectional view of a first stage of manufacture of the innerlayer panel 5100 illustrated in FIG. 6D. The article shown in FIG. 6A comprises a foil 5410, a first dielectric layer 5420 and a first conductive layer 5430 on a first side of the foil 5410, and a second dielectric layer 5422 and a second conductive layer 5432 on a second side of the foil 5410. A top plan view of the article in FIG. 6A can correspond in shape generally to the article shown in FIG. 5A, and the article can be manufactured in a similar manner. The article can be fired by performing a co-firing of the layers 5420 and 5430 followed by a co-firing of the layers 5422 and 5432. The foil 5410 may be pretreated, and can include underprint layers 5412, 5414.

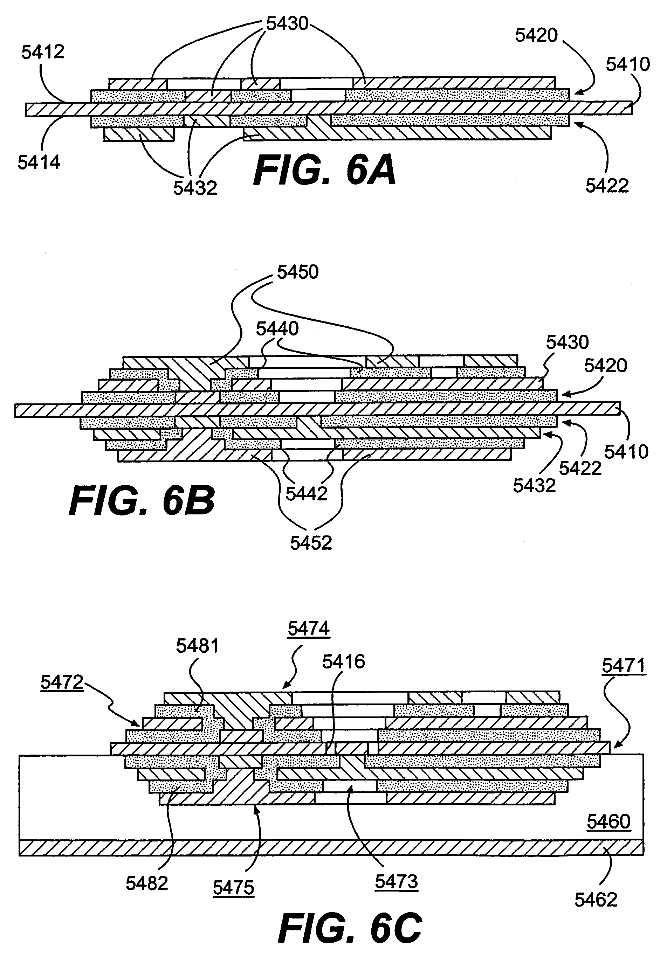

FIG. 6B is a sectional view of the next stage of manufacture of the innerlayer panel 5100. In FIG. 6B, a third dielectric layer 5440 is formed over the first conductive layer 5430. A third conductive layer 5450 is formed over the third dielectric layer 5440 and the article is fired. A fourth dielectric layer 5442 is formed over the second conductive layer 5432, and a fourth conductive layer 5452 is formed over the fourth dielectric layer 5442. The resulting article is then fired.

An alternative to the above method is to completely form the layers 5420, 5430, 5440 and 5450 on the first side of the foil 5410, and then co-fire the layers 5420, 5430, 5440 and 5450. The layers 5422, 5432, 5442 and 5452 are then formed on the second side of the foil 5410 and co-fired. In general, the boundaries between adjacent dielectric layers are removed upon co-firing. The boundaries are shown in FIG. 6B to illustrate the separate layers formed before firing.

FIG. 6C is a sectional view of the next stage of manufacture of the innerlayer panel 5100. Co-firing the article as described above results in a first two-layer dielectric 5481 on the first side of the foil 5410 (reference number 5410 is not used in FIG. 6C) and a second two-layer dielectric 5482 on the second side of the foil 5410. After firing, a laminate material 5460 is applied to the article on the second side of the foil 5410. A foil 5462 may be applied to the laminate material 5460.

After lamination, a photo-resist is applied to the foil 5410 and the foil 5410 is imaged, etched and stripped. A trench 5416 is etched in the foil 5410, and the edges of the foil 5410 are also etched to define a first electrode 5471, as shown in FIG. 6C. The trench 5416 may be, for example, annular, and may be similar in shape and size to the trench 4316 shown in FIG. 5D.

After etching, the article comprises the first electrode 5471, a second electrode 5472 that corresponds to the conductive layer 5430 (shown in FIG. 6B), a third electrode 5473 that corresponds to the conductive layer 5432, a fourth electrode 5474 that corresponds to the conductive layer 5450, and a fifth electrode 5475 that corresponds to the conductive layer 5452.

Referring to FIG. 6D, a laminate material 5470 is applied to the first side of the first foil electrode 5471, and a foil is applied to the laminate material 5470 (foil not shown). The foil applied to the laminate material 5470 is imaged, etched and stripped to form circuitry 5461, 5462. The foil 5462 (shown in FIG. 6C) is also etched to create circuitry 5464, 5466. Other circuitry may also be formed from the foil 5462.

FIG. 6D illustrates the finished innerlayer panel 5100, including the capacitor 5105, prior to incorporation into a printed wiring board. In Fig 6D, first and third circuit conductors 5571 and 5573 are preferably formed after incorporation into a multilayer board. The circuit conductors 5571 and 5573 may be formed, for example, by mechanical drilling and subsequent plating. A second circuit conductor 5572 may be formed at this stage as a microvia by laser drilling and plating.

The innerlayer panel 5100 includes a capacitor 5105 with five electrodes, two of which (electrodes 5472 and 5474) are located on a first side of the first foil electrode 5471, and two of which (electrodes 5473 and 5475) are located on a second side of the electrode 5471. The capacitor 5105 also includes two two-layer dielectrics 5481, 5482. As shown in FIG. 6D, the capacitor 5105 provides a high capacitance, and occupies a relatively small x-y area. In addition, the terminations of the electrodes are located within the footprints of the electrodes, reducing the contribution of the capacitor 5105 to circuit loop inductance.

FIG. 7A is a sectional view of an alternative embodiment of an innerlayer panel 6100 having electrodes formed on both sides of a foil electrode. The innerlayer panel 6100 can be incorporated in a printed wiring board, such as, for example, the printed wiring boards 1000, 2000, 3000, 4000 discussed above.

The innerlayer panel 6100 includes a capacitor 6105 having first, second, and third electrodes 6101, 6102, 6103, respectively. The first electrode 6101, and a portion 6109 of the second electrode 6102 are formed from a metallic foil. A trench 6110 is formed in the foil to isolate the first electrode 6101 from the second electrode 6102.

The first and second electrodes 6101, 6102 are separated by a first dielectric 6121, and the first and third electrodes 6101, 6103 are separated by a second dielectric 6122. A first circuit conductor 6571 connects to the first electrode 6101 and to circuitry 6581. A second circuit conductor 6572 connects to the second electrode 6102 and a third circuit conductor 6573 connects to the third electrode 6103. The second and third circuit conductors 6572, 6573 are connected by circuitry 6580, thereby electrically connecting the second and third electrodes 6102, 6103. The innerlayer panel 6100 can include laminate materials 6401 and 6402, and the circuitry 6580, 6581 can be formed from a foil deposited on the laminate material 6401. The circuit conductors 6571, 6572, 6573 can be, for example, plated vias. Connective circuitry, not shown in FIG. 7A, can also be formed on the laminate material 6402.

FIG. 7B is a sectional view of another alternative embodiment of an innerlayer panel 7100 having electrodes formed on both sides of a foil electrode. The innerlayer panel 7100 can be incorporated in a printed wiring board, such as any of the printed wiring board embodiments discussed above.

The innerlayer panel 7100 includes a capacitor 7105 having first, second, third, and fourth electrodes 7101, 7102, 7103, 7104, respectively. The first electrode 7101 can be formed from a metallic foil. A trench 7110 can be formed in the foil to isolate the first electrode 7101 from the second electrode 7102.

A two-layer first dielectric 7121 separates the second electrode 7102 from the first and third electrodes 7101, 7103. A second dielectric 7122 separates the first electrode 7101 from the fourth electrode 7104. A first circuit conductor 7571 connects to the first electrode 7101, which is electrically coupled to the third electrode 7103. A second circuit conductor 7572 connects to the second electrode 7102 and a third circuit conductor 7573 connects to the fourth electrode 7104. The second and third circuit conductors 7572 and 7573 are connected by circuitry 7580, thereby electrically connecting the fourth and second electrodes 7104, 7102. The first circuit conductor 7571 connects to circuitry 7581. The innerlayer panel 7100 can include laminate materials 7401 and 7402, and the circuitry 7580, 7581 can be formed from a foil on the laminate material 7401. The circuit conductors 7571, 7572, 7573 can be, for example, plated vias. Connective circuitry, not shown in FIG. 7B, can also be formed on the laminate material 7402.

The innerlayer panels 6100, 7100 of FIGS. 7A and 7B can be formed using manufacturing methods as described with reference to the innerlayer panel embodiments discussed above, and similar or identical materials can be used in their fabrication. As can be appreciated by those skilled in the art, the terminations of the electrodes of the capacitors 6105 and 7105 discussed above may be located within the footprints of the electrodes, reducing the contribution of the capacitors 6105, 7105 to circuit loop inductance.

The embodiments discussed above with reference to FIGS. 5A-7B, in which an innerlayer panel has electrodes on either side of an electrode, provide high capacitances in relatively small x-y surface areas. These embodiments are particularly useful when the x-y surface area in a device is limited. A printed wiring board constructed according to the above embodiments can include any number of innerlayer panels stacked with one or more capacitors connected, for example, in parallel, thereby providing high capacitance within a relatively small x-y area.

The embodiments discussed above are described as formed by fired-on-foil processes, which can involve co-firing of capacitor layers. Other methods and materials, however, can be used to form the printed wiring boards 1000, 2000, 3000, 4000, and the alternative innerlayer panel embodiments discussed above. For example, polymeric (non-ceramic) capacitors can also be formed from polymeric-based paste compositions that may contain fillers, such as barium titanate, to increase the dielectric constant. Polymeric capacitors can be formed in a manner similar to the above embodiments, except that printed layers are cured. Curing can be done at, for example, 150°C. Suitable polymer materials for the paste used to form the conductive layers include, for example, polymer thick-film electrodes. Suitable polymer materials for the paste used to form the dielectric layers include, for example, polymer thick-film dielectrics.

Thin film capacitors can also be coupled in parallel to increase capacitance density. Thin film capacitors can be formed by first selectively depositing the dielectric by chemical solution deposition, sputtering or anodization of a previously sputtered metal. Selective deposition can be achieved by use of masks, for example. Electrodes can be applied by sputtering through shadow masks and, if required, followed by plating to increase thickness. Alternatively, a thick film composition may be printed and either fired or cured on the dielectric to form the electrodes.

FIGS. 8A-8G illustrate a method of manufacturing a first embodiment of an innerlayer panel 8100 having multiple capacitors formed from a single foil "carrier." FIG. 8H illustrates the finished innerlayer panel 8100. In the innerlayer panel 8100, the capacitors 8105 are grouped, or "ganged" together in a single metallic foil carrier or substrate. FIG. 9 is a schematic sectional view of a printed wiring board embodiment 8000 comprised of the innerlayer panel 8100, and additional innerlayer panels 8200, 8300, 8400.

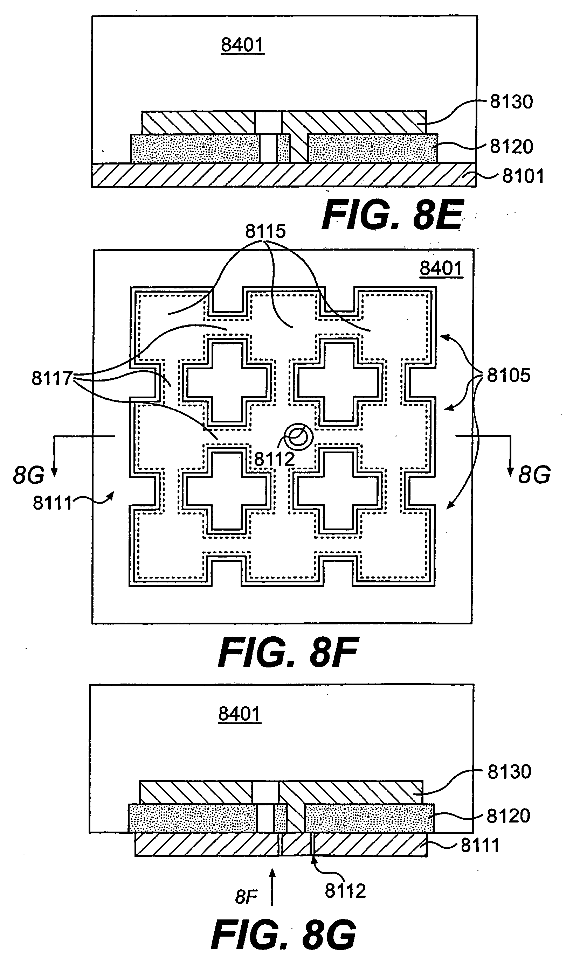

FIG. 8A is a plan view of a first stage of manufacturing the innerlayer panel 8100 (FIG. 8H). FIG. 8B is a front elevational view taken on line 8B-8B in FIG. 8A. Referring to FIG. 8B, a metallic foil 8101 is provided. The foil 8101 serves as the "carrier" for the innerlayer panel 8100 and one set of electrodes 8115 (shown in FIG. 8F) for the capacitors 8105 are formed from the foil 8101. The foil 8101 may be of a type generally available in the industry. For example, the foil 8101 may be copper, copper-invar-copper, invar, or nickel, nickel-coated copper.

The foil 8101 may be pretreated, for example, by applying and firing an underprint 8102. In FIG. 8B, the underprint 8102 is indicated as a surface coating on the foil 8101. The underprint 8102 may be formed, for example, from a paste applied to the foil 8101.

Referring to FIG. 8B, a dielectric material is screen-printed onto the pretreated foil 8101, forming a first dielectric layer 8121. The dielectric material may be, for example, a thick-film dielectric ink. The dielectric ink may be formed of, for example, a paste. The first dielectric layer 8121 is then dried. As shown in FIG. 8A, the dielectric layer 8121 outlines the general shape that the capacitors 8105 (shown in FIG. 8F) will have in the completed device. A second dielectric layer 8122 is then applied, and dried. In an alternative embodiment, a single layer of dielectric material may be deposited through a mesh screen that is coarser than the mesh screen used to form the two separate dielectric layers 8121, 8122.

A first through-hole or aperture 8125 and a second aperture 8126 extend through both of the dielectric layers 8121, 8122. Referring to FIG. 8A, the apertures 8125, 8126 are illustrated as circular in cross section, but other cross sections may be used. The diameter of the apertures 8125, 8126 may be in the range of, for example, about 40 - 100 mils (1 - 2.54 mn diameters of the aperture 8125, 8126 can be selected to, for example, accommodate screen printing tolerances.

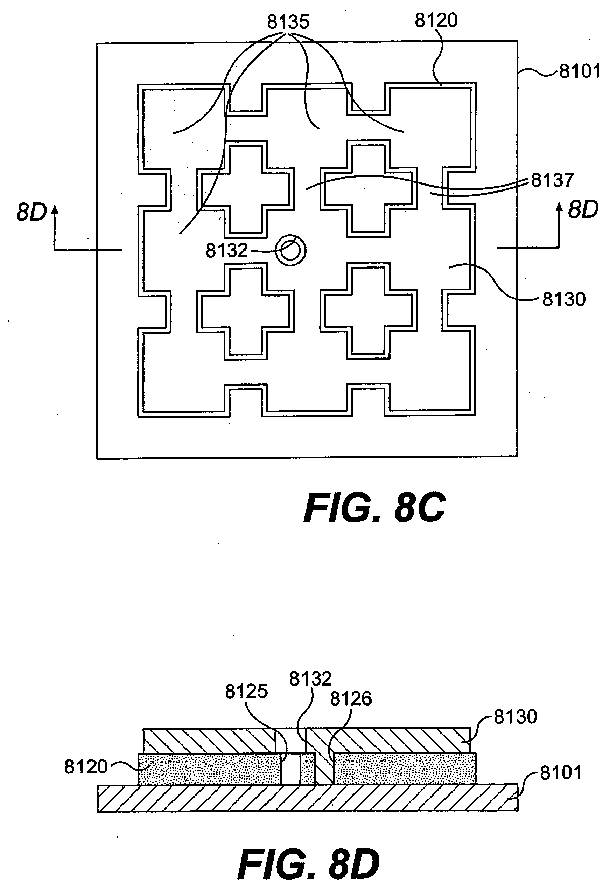

FIG. 8C is a top plan view of a next stage of manufacture of the innerlayer panel 8100, and FIG. 8D is a sectional view taken on line 8D-8D in FIG. 8C. Referring to FIG. 8D, a conductive layer 8130 is formed over the second dielectric layer 8122 (not shown in FIG. 8D) and dried. The conductive layer 8130 may be formed by, for example, screen-printing a thick-film metallic ink. The conductive layer includes a through-hole aperture 8132, aligned with the through-hole aperture 8125. In general, the plan surface area of the dielectric layer 8122 should be larger than that of the conductive layer 8130. The conductive layer 8130 is formed to extend to contact the foil 8101 through the through-hole aperture 8126.

The first dielectric layer 8121, the second dielectric layer 8122, and the conductive layer 8130 are then co-fired. The post-fired structure is shown in FIGS. 8C and 8D. A dielectric layer 8120 results from the co-firing step, and the individual dielectric layers 8121, 8122 are therefore not illustrated in FIG. 8D. The co-firing can take place, for example, in an N₂ environment at about 900°C. After firing, the conductive layer 8130 and the foil 8101 have a strong bond to the dielectric layer 8120 that results from the co-firing step.

As shown in FIG. 8C, the conductive layer 8130 comprises several discrete first electrode portions 8135, which can be described as individual "electrodes." The conductive layer 8130 therefore can also be described as a first "electrode" layer 8130. The plurality of first electrodes 8135 are connected by first conductive portions 8137, which are also formed from the layer 8130.

Referring to FIG. 8E, the article resulting from the co-firing step may be laminated to a laminate material 8401. The lamination can be performed, for example, using FR4 prepreg in standard printing wiring board processes. Type 106 epoxy prepreg may also be used.

FIG. 8F is a plan view of a next step of manufacturing the innerlayer panel 8100. FIG. 8G is a sectional view taken on line 8G-8G in FIG. 8F. FIG. 8F is seen from the direction of arrow 8F in FIG. 8G.

Referring to FIGS. 8F and 8G, after lamination, a photo-resist is applied to the foil 8101 (reference number 8101 is not used in FIG. 8G) and the foil 8101 is imaged, etched and stripped using standard printing wiring board processing conditions. From the perspective of FIG. 8G, the photoresist is applied to the bottom side of the foil 8101. The etching process produces a second electrode layer 8111 from the foil 8101. A trench 8112 isolates the first electrode layer 8130 from the second electrode layer 8111 so that through-hole vias can be connected to both of the electrode layers 8111, 8130.

Referring to FIG. 8F, the second electrode layer 8111 comprises a plurality of individual second electrodes 8115 (FIG. 8F) that may generally correspond in shape and size to the first electrodes 8135 in the first electrode layer 8130 (FIG. 8C). The individual second electrodes 8115 are connected by a plurality of second conductive portions 8117.

Each opposed first electrode 8135/second electrode 8115 pair, along with the sandwiched portion of the dielectric layer 8120, forms a capacitor 8105. In FIG. 8F, nine capacitors 8105 are illustrated, but any number of capacitors 8105 can be formed from a single foil carrier. In addition, while all of the capacitors 8105 have the same shape from a plan view perspective, one or more capacitors may have a different plan shape.

FIG. 8H is a sectional view in front elevation of the innerlayer panel 8100 after circuit conductors have been formed in the panel 8100. FIG. 8H can represent an isolated view of the innerlayer panel 8100 after it has been incorporated in a printed wiring board. In FIG. 8H, a first circuit conductor 8151 connects to the first electrodes 8135 of the first electrode layer 8130 (FIG. 8F). A second circuit conductor 8152 connects to the second electrodes 8115 of the second electrode layer 8111 (FIG. 8C). The first and second circuit conductors 8151, 8152 can be, for example, plated vias. The location of circuit conductor 8152 may vary within the footprint of the electrode. Furthermore, the through -hole apertures, 8125 and 8132, may or may not be a necessary feature dependent upon the final innerlayer panel embodiment.

FIG. 8I is a sectional view in front elevation of an alternative arrangement of an innerlayer panel 8100'. FIG. 8I can represent, for example, an isolated view of the innerlayer panel 8100' after it has been incorporated in a printed wiring board and plated through-hole vias have been drilled through the printed wiring board. In FIG. 8I, a first through-hole circuit conductor 8252 connects to a first electrode layer 8230, which may have a form similar to the first electrode layer 8130 shown in FIG. 8H. A second through-hole circuit conductor 8152 connects to a second electrode layer 8211, which may have a form similar to the second electrode layer 8111 in FIG. 8H.

As shown in FIGS. 8H and 8I, the innerlayer panel embodiments 8100, 8100' can be connected to circuit conductors extending through either side of the panels 8100, 8100', or, through-hole conductors can extend through the panels 8100, 8100' to connect to the electrode layers.

FIG. 9 schematically illustrates the innerlayer panel 8100 after integration into a printed wiring board 8000 and after through-hole vias have been drilled and plated. Each of the vias connects with one of the electrode layers 8111, 8130 in the innerlayer panel 8100. The innerlayer panels 8100, 8200, 8300, 8400 and so on can be bonded together using, for example, dielectric prepregs in lamination processes. Each of the innerlayer panels 8100, 8200, 8300, 8400 can have a different design, including differing arrangements of active and passive circuit elements. One or more of the innerlayer panels 8200, 8300, 8400 can have a design similar or identical to the innerlayer panel 8100. In addition, one or more of the capacitors from different innerlayer panels can be connected in parallel, as discussed with reference to FIGS. 1A-4 above.

The term "innerlayer panel" does not imply that the panels must be sandwiched in the interior of the printed wiring board 8000, and the innerlayer panels 8100, 8200, 8300, 8400 can also be located on the outside layers of the printed wiring board 8000. The printed wiring board 8000 may be laminated in multiple stages. For example, subassemblies of innerlayer panels may be processed and laminated, and one or more subassemblies can subsequently be laminated together to form the finished printed wiring board 8000. Circuit conductors may also be formed to extend through one or more, or all of the innerlayer panels in the printed wiring board 8000.

In the embodiments shown in FIGS. 8A-8H and 9 above, the shape and arrangement of the individual electrodes 8115, 8135 and the conductive portions 8117, 8137 can vary. For example, FIG. 10A is a symbolic representation of an alternative arrangement of first electrodes 1015, which may accordingly also be used for the corresponding second electrodes in an innerlayer panel. In FIG. 10A, the first electrodes 1015 have an octagonal shape. FIG. 10B is a second alternative arrangement of first electrodes 1115, which may also be used for the corresponding second electrodes in an innerlayer panel. In FIG. 10B, the electrodes 1115 have a circular shape. Differing shapes for the electrodes and dielectric layers may be selected to maximize an allowable surface area of the layers, while ensuring that the layers do not crack during firing.

The circuit conductors 8151, 8152 and 8251, 8252 are shown in FIGS. 8H and 8I as connected to the electrode portions of the electrode layers. Alternatively, the circuit conductors can be connected to the first and second conductive portions 8137, 8117 (shown in FIGS. 8C and 8F). In that case, through-holes may instead be provided in the circuit conductor portions of the layers 8111, 8130.

The innerlayer panel embodiments discussed above provide a high capacitance by forming multiple capacitors from a single foil carrier. These embodiments are particularly desirable when the z-dimension of a system or device is limited, and the x-y dimension is less constrained.

The above embodiments also avoid the problems associated with conventionally fired ceramic thick-film capacitors, which include large continuous dielectric and electrode areas in order to provide a high capacitance. During firing, TCE stresses caused by mismatches between a metallic foil and deposited layers are directly proportional to the area of the fired dielectric/electrode layer. According to the above embodiments, by forming individual electrodes, large surface areas of fired layers are avoided. The total capacitance provided by the capacitors, however, is large. The TCE mismatch problems associated with forming a single large continuous dielectric/electrode area are thereby avoided while achieving a large capacitance. The above embodiments also allow for routing of through-holes through the innerlayer panels.

The embodiments discussed above are described as formed by fired-on-foil processes, which can involve co-firing of capacitor layers. Other methods and materials, however, can be used to form the innerlayer panels in the printed wiring boards 1000, 2000, 3000, 4000, 5000, 8000. For example, thin film ceramic capacitors can be formed via a number of processes that yield thin ceramic layers of less than, for example, 1 micron. Examples of such materials include barium titanate or alumina, which can be deposited by sol-gel techniques or sputtering, for example. Polymeric (non-ceramic) capacitors can also be formed from polymeric-based paste compositions that may contain barium titanate to increase the dielectric constant. Polymeric capacitors can be formed in a manner similar to the above embodiments, except that layers are not fired, but cured. Suitable materials for paste used to form polymer conductive layers include, for example, polymer thick-film conductors, and suitable materials for paste used to form polymer dielectric layers include, for example, polymer thick-film dielectrics.

In the embodiments discussed in this specification, the term "paste" may correspond to a conventional term used in the electronic materials industry, and generally refers to a thick-film composition. Typically, the metal component of the underprint paste is matched to the metal in the metal foil. For example, if a copper foil were used, then a copper paste could be used as the underprint. Examples of other applications would be pairing silver and nickel foils with a similar metal underprint paste. Thick-film pastes may be used to form both the underprint and the passive components.

Generally, thick-film pastes comprise finely divided particles of ceramic, glass, metal or other solids dispersed in polymers dissolved in a mixture of plasticizer, dispersing agent and organic solvent. Preferred capacitor pastes for use on copper foil have an organic vehicle with good burnout in a nitrogen atmosphere. Such vehicles generally contain very small amounts of resin, such as high molecular weight ethyl cellulose, where only small amounts are necessary to generate a viscosity suitable for screen-printing. Additionally, an oxidizing component such as barium nitrate powder, blended into the dielectric powder mixture, helps the organic component bum out in the nitrogen atmosphere. Solids are mixed with an essentially inert liquid medium (the "vehicle"), then dispersed on a three-roll mill to form a paste-like composition suitable for screen-printing. Any essentially inert liquid may be used as the vehicle. For example, various organic liquids, with or without thickening and/or stabilizing agents and/or other common additives, may be used as the vehicle.

High K thick-film dielectric pastes generally contain at least one high K functional phase powder and at least one glass powder dispersed in a vehicle system composed of at least one resin and a solvent. The vehicle system is designed to be screen-printed to provide a dense and spatially well-defined film. The high K functional phase powders can comprise perovskite-type ferroelectric compositions with the general formula ABO₃. Examples of such compositions include BaTiO₃; SrTiO₃; PbTiO₃; CaTiO₃; PbZrO₃; BaZrO₃ and SrZrO₃. Other compositions are also possible by substitution of alternative elements into the A and/or B position, such as Pb(Mg_{1/3} Nb_{2/3})O₃ and Pb(Zn_{1/3} Nb_{2/3})O₃. TiO₂ and SrBi₂Ta₂O₉ are other possible high K materials.

Doped and mixed metal versions of the above compositions are also suitable. Doping and mixing is done primarily to achieve the necessary end-use property specifications such as, for example, the necessary temperature coefficient of capacitance (TCC) in order for the material to meet industry definitions, such as "X7R" or "Z5U" standards.

The glasses in the pastes can be, for example, Ca-Al borosilicates, Pb-Ba borosilicates, Mg-Al silicates, rare earth borates, and other similar glass compositions. High K glass-ceramic powders, such as lead germanate (Pb₅Ge₃O₁₁) compositions, are preferred.

Pastes used to form conductive layers may be based on metallic powders of either copper, nickel, silver, silver-containing precious metal compositions, or mixtures of these compounds. Copper powder compositions are preferred.

The embodiments described in this specification have many applications. For example, the capacitor embodiments can be used within organic printed circuit boards, IC packages, applications of said structures in decoupling applications, and devices such as IC modules or handheld device motherboards. The above embodiments provide added flexibility in device design because of the ability to limit the x-y, or the z dimension in the above embodiments.

Capacitor structures described in the above embodiments may be combined with buried resistors and/or inductors to create more complex structures which are likely to find application in practice such as filters. Buried resistors can be created and integrated into circuit boards using a variety of means known in the art including metal thin film, polymer thick film, and ceramic fired-on-foil thick film. Components such as resistors and capacitors can be combined to create integrated passives devices and structures such as arrays and networks within printed circuit boards without the need for any semiconductor devices on the surface of the board.

In the above embodiments, the electrode layers are described as formed by screen-printing. Other methods, however, such as deposition by sputtering or evaporation of electrode metals onto dielectric layer surfaces may also be used.

The shapes of the capacitor embodiments in top plan view are generally rectangular. However, the capacitor electrodes, dielectrics, and other components and layers can have other surface area shapes, such as, for example, round, oblong, oval or polygonal shapes.

The foregoing description illustrates and describes the preferred embodiments of the present invention. It is to be understood that the invention is capable of use in various other combinations, modifications, and environments and is capable of changes or modifications within the scope of the invention which is defined by the claims.

## Claims

1. A printed wiring board, comprising:
a first innerlayer panel, the first innerlayer panel comprising:
a first electrode;
a dielectric disposed over the first electrode; and
a second electrode disposed over the dielectric, wherein the first electrode, the dielectric and the second electrode form a first capacitor; and
a second innerlayer panel, the second innerlayer panel comprising:
a first electrode;
a dielectric disposed over the first electrode; and
a second electrode disposed over the dielectric, wherein the first electrode, the dielectric and the second electrode form a second capacitor,
wherein the second innerlayer panel is stacked with the first innerlayer panel, the respective first electrodes are electrically coupled, and the respective second electrodes are electrically coupled, thereby connecting the first and second capacitors in parallel.

2. The printed wiring board of claim 1, comprising:
a third innerlayer panel, the third innerlayer panel comprising:
a first electrode;
a dielectric disposed over the first electrode; and
a second electrode disposed over the dielectric, wherein the first electrode, the dielectric and the second electrode form a third capacitor,
wherein the third innerlayer panel is stacked with the first and second innerlayer panels, the respective first electrodes are electrically coupled, and the respective second electrodes are electrically coupled, thereby connecting the first, second and third capacitors in parallel.

3. The printed wiring board of claim 1, wherein the first innerlayer panel comprises:
a third electrode spaced from the second electrode by the dielectric and electrically coupled to the first electrode, wherein the dielectric is a two-layer dielectric.

4. The printed wiring board of claim 3, wherein the first innerlayer panel comprises:
a fourth electrode spaced from the third electrode by the dielectric and electrically coupled to the second electrode, wherein the dielectric is a three-layer dielectric.

5. The printed wiring board of claim 1, wherein:
the respective first electrodes are electrically coupled by a first conductive via; and
the respective second electrodes are electrically coupled by a second conductive via.

6. A method of making a printed wiring board, comprising:
forming a first innerlayer panel, wherein forming the first innerlayer panel comprises:
forming a first electrode;
forming a dielectric over the first electrode; and
forming a second electrode over the dielectric, wherein the first electrode, the second electrode, and the dielectric form a first capacitor;
forming a second innerlayer panel, wherein forming the second innerlayer panel comprises:
forming a first electrode;
forming a dielectric over the first electrode; and
forming a second electrode over the dielectric, wherein the first electrode, the second electrode, and the dielectric form a second capacitor;
stacking the first and second innerlayer panels; electrically coupling the respective first electrodes; and
electrically coupling the respective second electrodes, thereby connecting the first and second capacitors in parallel.

7. The method of claim 6, further comprising:
forming a third innerlayer panel, wherein forming the third innerlayer panel comprises:
forming a first electrode;
forming a dielectric over the first electrode; and
forming a second electrode over the dielectric, wherein the first electrode, the second electrode and the dielectric form a third capacitor;
stacking the third innerlayer panel with the first and second innerlayer panels;
electrically coupling the first electrode of the third capacitor to the first electrodes of the first and second capacitors; and
electrically coupling the second electrode of the third capacitor to the second electrodes of the first and second capacitors.

8. The method of claim 6, wherein forming the first innerlayer panel comprises:
forming a third electrode spaced from the second electrode by the dielectric and electrically coupled to the first electrode,
wherein the dielectric is a two-layer dielectric.

9. The method of claim 8, wherein forming the first innerlayer panel comprises:
forming a fourth electrode spaced from the third electrode by the dielectric and electrically coupled to the second electrode,
wherein the dielectric is a three-layer dielectric.

10. The method of claim 6, wherein:
electrically coupling the first electrodes comprises forming a first conductive via; and
electrically coupling the second electrodes comprises forming a second conductive via.

11. A printed wiring board, comprising:
a plurality of stacked innerlayer panels, at least one of the innerlayer panels comprising:
a first electrode made from a foil;
a first dielectric disposed over a first side the first electrode;
a second dielectric disposed over a second side of the first electrode;
a second electrode disposed over the first dielectric; and
a third electrode disposed over the second dielectric,
wherein the first electrode, the first dielectric, the second dielectric, the second electrode, and the third electrode form a capacitor.

12. The printed wiring board of claim 11, wherein:
a termination of the first electrode is within a footprint of the first electrode;
a termination of the second electrode is within a footprint of the second electrode; and
a spacing between the terminations is less than a width of the first electrode.

13. The printed wiring board of claim 11, wherein the second electrode is electrically coupled to the third electrode.

14. The printed wiring board of claim 11, comprising:
a laminate material disposed over the first side of the first electrode;
a first conductor electrically coupled to the first electrode, wherein the first conductor extends through the laminate material; and
a second conductor electrically coupled to the second electrode.

15. The printed wiring board of claim 11, comprising:
a fourth electrode disposed over the first dielectric and electrically coupled to the first electrode.

16. The printed wiring board of claim 15, comprising:
a fifth electrode disposed over the second dielectric and electrically coupled to the first electrode, wherein
the second and third electrodes are electrically coupled.

17. A method of making a printed wiring board, comprising:
forming a plurality of innerlayer panels, wherein forming at least one of the innerlayer panels comprises:
providing a metallic foil;
forming a first dielectric over a first side of the foil;
forming a second electrode over the first dielectric;
forming a second dielectric over a second side of the foil;
forming a third electrode over the second dielectric;
forming a first electrode from the foil; and
stacking the plurality of innerlayer panels.

18. The method of claim 17, comprising:
forming a laminate material over the first side of the metallic foil;
forming a first conductor, wherein the first conductor electrically connects to the first electrode; and
forming a second conductor, wherein the second conductor electrically connects to the second electrode.

19. The method of claim 17, comprising:
forming a fourth electrode over the first dielectric; and
forming a fifth electrode over the second dielectric.

20. The method of claim 17, wherein forming one or more of the electrodes includes a firing.

21. A printed wiring board, comprising:
a plurality of stacked innerlayer panels, at least one of the innerlayer panels comprising:
a plurality of first electrodes disposed in a plane;
a plurality of first conductive portions electrically connecting the first electrodes;
a plurality of second electrodes formed from a metallic foil;
a plurality of second conductive portions electrically connecting the second electrodes; and
a dielectric separating the first electrodes from the second electrodes, wherein
the first and second electrodes are arranged so that the first electrodes are spaced across the dielectric from the second electrodes to form a plurality of capacitors.

22. The printed wiring board of claim 21, comprising:
a first laminate material disposed over the plurality of first electrodes; and
a second laminate material disposed over the plurality of second electrodes.

23. The printed wiring board of claim 22, comprising:
a conductor extending through at least one of the first laminate material and the second laminate material and electrically coupled to the plurality of first electrodes.

24. The printed wiring board of claim 23, wherein the conductor extends through the dielectric.

25. The printed wiring board of claim 21, wherein the first electrodes are substantially identical in plan view shape to the second electrodes.

26. A method of making a printed wiring board, comprising:
forming a plurality of innerlayer panels, wherein forming at least one of the innerlayer panels comprises:
providing a metallic foil;
forming a dielectric layer over the metallic foil;
forming a plurality of first electrodes and a plurality of first conductive portions over the dielectric layer, wherein the first conductive portions electrically connect the first electrodes; and
forming a plurality of second electrodes and a plurality of second conductive portions from the metallic foil, wherein the plurality of second conductive portions electrically connect the second electrodes, and wherein
the first and second electrodes are arranged so that the first electrodes are spaced across the dielectric layer from the second electrodes to form a plurality of capacitors; and
stacking the innerlayer panels.

27. The method of claim 26, wherein forming the at least one innerlayer panel comprises:
forming a first laminate material over the plurality of first electrodes; and
forming a second laminate material over the plurality of second electrodes.

28. The method of claim 26, wherein forming the plurality of first electrodes and the plurality of first conductive portions comprises:
depositing a conductive layer over the dielectric layer.

29. The method of claim 28, wherein forming the plurality of first electrodes and the plurality of first conductive portions comprises:
firing the conductive layer and the dielectric layer.

30. The method of claim 26, wherein forming the plurality of second electrodes and the plurality of second conductive portions from the metallic foil comprises:
etching the metallic foil.
